(19) Europäisches Patentamt / European Patent Office / Office européen des brevets

(11) **EP 4 354 351 B1**

(12) **FASCICULE DE BREVET EUROPEEN**

(45) Date de publication et mention
de la délivrance du brevet:
**08.04.2026 Bulletin 2026/15**

(21) Numéro de dépôt: **23203305.0**

(22) Date de dépôt: **12.10.2023**

(51) Classification Internationale des Brevets (IPC):
**G06N 3/063** *(2023.01)* **G06N 3/0464** *(2023.01)*
**G06N 3/0495** *(2023.01)* **G11C 11/54** *(2006.01)*
**G11C 13/00** *(2006.01)* **G06F 7/544** *(2006.01)*

(52) Classification Coopérative des Brevets (CPC):
**G06N 3/063; G06F 7/5443; G06F 15/7821;**
**G06N 3/0464; G06N 3/0495; G11C 11/54;**
**G11C 13/0026; G11C 13/004; G11C 13/0061;**
G06F 2207/4814; G11C 2013/0042; G11C 2213/79

(54) **CIRCUIT ÉLECTRONIQUE À BASE DE CELLULES RRAM**

ELEKTRONISCHE SCHALTUNG AUF RRAM-ZELLENBASIS

ELECTRONIC CIRCUIT BASED ON RRAM CELLS

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **14.10.2022 FR 2210591**

(43) Date de publication de la demande:
**17.04.2024 Bulletin 2024/16**

(73) Titulaires:
- **Commissariat à l'Energie Atomique et aux
Energies
Alternatives
75015 Paris (FR)**
- **Centre National de la Recherche Scientifique
75016 Paris (FR)**
- **Université d'Aix Marseille
13007 Marseille (FR)**

(72) Inventeurs:
- **EZZADEEN, Mona
38054 Grenoble Cedex 9 (FR)**
- **GIRAUD, Bastien
38054 Grenoble Cedex 9 (FR)**
- **NOEL, Jean-Philippe
38054 Grenoble Cedex 9 (FR)**
- **PORTAL, Jean-Michel
13119 Saint Savournin (FR)**

(74) Mandataire: **Lavoix
2, place d'Estienne d'Orves
75441 Paris Cedex 09 (FR)**

(56) Documents cités:
**US-A1- 2019 043 575**

- **WANG LINFANG ET AL: "Efficient and Robust
Nonvolatile Computing-In-Memory Based on
Voltage Division in 2T2R RRAM With Input-
Dependent Sensing Control", IEEE
TRANSACTIONS ON CIRCUITS AND SYSTEMS
II: EXPRESS BRIEFS, IEEE, USA, vol. 68, no. 5, 19
March 2021 (2021-03-19), pages 1640 - 1644,
XP011851879, ISSN: 1549-7747, [retrieved on
20210429], DOI: 10.1109/TCSII.2021.3067385**
- **EZZADEEN M ET AL: "Low-Overhead
Implementation of Binarized Neural Networks
Employing Robust 2T2R Resistive RAM
Bridges", ESSDERC 2021 - IEEE 51ST
EUROPEAN SOLID-STATE DEVICE RESEARCH
CONFERENCE (ESSDERC), IEEE, 13 September
2021 (2021-09-13), pages 83 - 86, XP034048099,
DOI: 10.1109/ESSDERC53440.2021.9631381**
- **CHEN YUZONG ET AL: "Reconfigurable 2T2R
ReRAM Architecture for Versatile Data Storage
and Computing In-Memory", IEEE
TRANSACTIONS ON VERY LARGE SCALE
INTEGRATION (VLSI) SYSTEMS, IEEE SERVICE
CENTER, PISCATAWAY, NJ, USA, vol. 28, no. 12,
20 October 2020 (2020-10-20), pages 2636 - 2649,
XP011822726, ISSN: 1063-8210, [retrieved on
20201125], DOI: 10.1109/TVLSI.2020.3028848**

**Description**

La présente invention concerne un circuit électronique propre à mettre en œuvre des opérations de calcul fournissant chacune une sortie binaire.

L'invention concerne tout type d'application utilisant des opérations appliquées à des opérandes binaires, notamment des applications utilisant des réseaux de neurones artificiels binaires, également appelés BNN (de l'anglais *Binary Neural Network*).

Un réseau de neurones est généralement composé d'une succession de couches de neurones dont chacune prend ses entrées sur les sorties de la couche précédente. Plus précisément, chaque couche comprend des neurones prenant leurs entrées sur les sorties des neurones de la couche précédente. Chaque couche est reliée à la suivante par une pluralité de synapses. Un poids synaptique est associé à chaque synapse. C'est un nombre, tel qu'un nombre binaire, ou encore une distribution, qui prend des valeurs positives comme négatives. Dans le cas d'une couche dense, l'entrée d'un neurone est la somme pondérée des sorties des neurones de la couche précédente, la pondération étant faite par les poids synaptiques et suivie d'une activation via une fonction d'activation.

Il est donc souhaitable de développer des architectures matérielles dédiées, entremêlant mémoire et calcul, pour réaliser des réseaux de neurones rapides, à faible consommation et capables d'apprendre en temps réel.

De telles architectures matérielles dédiées visent plus généralement à effectuer efficacement des opérations appliquées à des opérandes binaires.

Il est connu un réseau de neurones reposant sur des technologies de type optique.

Un autre champ de recherche porte sur la réalisation de neurones et de synapses de réseaux de neurones sur la base d'une technologie de type CMOS (de l'anglais *Complementary Metal-Oxide-Semiconductor*). Le sigle CMOS désigne aussi bien un procédé de fabrication qu'un composant obtenu par un tel procédé de fabrication.

Toutefois, selon chacune de ces technologies, chaque neurone occupe plusieurs dizaines de micromètres de côté. En outre, chaque synapse occupe également plusieurs dizaines de micromètres de côté. Il en résulte que, sur une surface limitée correspondant par exemple à une puce électronique, le nombre de neurones et de synapses qui peuvent être intégrés est limité, ce qui résulte en une diminution des performances du réseau de neurones.

De ce fait, pour diminuer l'encombrement, il est spécifiquement étudié des architectures dans lesquelles les synapses sont memristives.

Des synapses memristives sont des synapses utilisant des memristors. En électronique, le memristor (ou memristance) est un composant électronique passif. Le nom est un mot-valise formé à partir des deux mots anglais memory et resistor. Un memristor est un composant de mémoire non-volatile, la valeur de sa résistance électrique changeant avec l'application d'une tension pendant une certaine durée et restant à cette valeur en l'absence de tension.

Des exemples d'une telle implémentation sont proposés dans les articles suivants :

- « A Fully Integrated Analog ReRAM Based 78.4TOPS/W Compute-In-Memory Chip with Fully Parallel MAC Computing » de Q. Liu et al. (2020) ;
- *« A 1Mb Multibit ReRAM Computing-In-Memory Macro with 14.6ns Parallel MAC Computing Time for CNN Based AI Edge Processors »* de C. Xue et al. (2019) ;
- *« A 22nm 4Mb 8b-Precision ReRAM Computing-in-Memory Macro with 11.91 to 195.7TOPS/W for Tiny AI Edge Devices »* de C. Xue et al. (2021) ;
- « A 16Mb dual-mode ReRAM macro with sub-14ns computing-in-memory and memory functions enabled by self-write termination scheme » de W. Chen et al. (2017) ; et
- « Embedded 1-Mb ReRAM-Based Computing-in-Memory Macro With Multibit Input and Weight for CNN-Based AI Edge Processors » de C. Xue et al. (2019).

Selon ces articles, l'approche consiste à stocker les poids d'un neurone au sein d'une colonne de cellules mémoire RRAM ou ReRAM (de l'anglais *Resistive Random-Access Memory*), et d'appliquer les entrées (activations) sur les lignes de mot, généralement notées WL (de l'anglais *Word Line*), de cette colonne (une tension positive étant appliquée sur une ligne de bit associée), généralement notée BL (de l'anglais *Bit Line*). Les tensions d'entrées peuvent être binaires (transistors d'accès ouvert ou fermé), ou bien prendre plusieurs valeurs possibles dans le cas d'entrées multi-bits. Un poids égal à 1 est généralement codé par un état de faible résistance, noté LRS (de l'anglais *Low Resistance State*), et un poids égal à 0 par un état de forte résistance, noté HRS (de l'anglais *High Resistance State*). Si l'entrée correspondant à un poids donné est égale à 1, il en résultera - par la loi d'Ohm - un courant au sein de la cellule porteuse de la multiplication entre l'entrée et le poids. Si le poids est égal à 1, le courant est fort (car la résistance est faible), et si le poids est égal à 0, le courant est faible.

Les cellules étant connectées via des lignes de source, généralement notées SL (de l'anglais *Source Line*), les courants s'additionnent via la loi de Kirchhoff, résultant ainsi en une opération MAC (de l'anglais *Multiply And Accumulate*) bien connue pour l'inférence des réseaux de neurones. Un circuit de comparateur calcule la sortie effective du neurone en comparant le résultat de l'opération MAC à une valeur de référence.

Cependant, ces circuits neuromorphiques souffrent aujourd'hui de la trop grande variabilité des cellules mémoire résistives, en raison de la faible maturité de leur fabrication. Par conséquent, ces approches sont limitées en terme de nombre d'opérandes d'une opération MAC, typiquement à 9 entrées. De plus, toujours en raison de la forte variabilité des cellules mémoire, ces approches nécessitent une circuiterie complexe de comparaison de l'opération MAC aux différentes valeurs de seuil possibles, résultant en une surface et une consommation importantes.

Une autre approche est présentée dans l'article « Efficient and Robust Nonvolatile Computing-In-Memory Based on Voltage Division in 2T2R RRAM With Input-Dependent Sensing Control » de L. Wang et al. (2021). Elle consiste à effectuer l'accumulation via un pont résistif et non une accumulation de courant. Cette approche utilise des colonnes de cellules mémoire RRAM résultant de la fusion de la ligne de source SL de deux colonnes (structure 2T2R pour 2 Transistors et 2 Résistances, une paire de commutateurs et une paire de memristors). Chaque colonne présente ainsi une paire de lignes de bit complémentaires BL, BLb et une ligne de source SL. Deux résistances sont utilisées pour coder chaque poids en différentiel (HRS-LRS ou LRS-HRS). Une tension est ensuite appliquée entre les lignes de bit complémentaires BL, BLb de la colonne, créant ainsi un pont résistif entre les résistances des côtés gauche et droit de la colonne. La tension résultante correspond au résultat de l'opération MAC. Bien que permettant une plus grande robustesse face à la variabilité des neurones, cette approche présente les mêmes inconvénients que la précédente en terme de complexité et de surface des comparateurs nécessaires en bas de colonne, et semble toujours limitée à 9 entrées.

Enfin, une dernière approche est présentée dans l'article « Low-Overhead Implementation of Binarized Neural Networks Employing Robust 2T2R Resistive RAM Bridges » de M. Ezzadeen et al. (2021). Elle consiste à appliquer les entrées en différentiel sur les lignes de bit complémentaires BL, BLb (et non plus sur les lignes de mot WL), en activant une ligne de mot respective de la matrice de cellules mémoire. Les poids sont codés de manière différentielle dans des cellules 2T2R. Il en résulte une structure en pont résistif au sein de chaque cellule 2T2R, résultant en une opération de ou-exclusif, ou XOR, en sortie de chaque ligne de source SL. L'opération de multiplication binaire étant équivalente à une opération de non-ou-exclusif, ou XNOR, un simple inverseur en bout de ligne de source SL permet de produire le résultat de l'opération XNOR. L'accumulation est effectuée par un pont capacitif, en connectant chaque sortie d'inverseur à une capacité, et en connectant toutes les capacités d'autre part ensemble pour former le pont. Cette approche a pour avantage d'être extrêmement robuste face à la variabilité des cellules (grâce à l'utilisation de capacités, technologie mature) malgré un faible impact surfacique (simple inverseur par colonne). Par sa robustesse, elle permet également d'implémenter de très grands neurones (jusqu'à 513 entrées), en réalisant en une fois (un même cycle de calcul) la sommation des contributions d'un grand nombre d'entrées dans la mesure où toutes les colonnes sont activées en même temps pour faire le calcul pour un neurone associé à une rangée de la matrice. En outre, les cellules mémoire codant les poids sont en pratique plus compactes, car il suffit d'avoir une unique cellule 2T-2R et une unique ligne de mot par rangée. Cependant, un seul neurone peut réaliser un calcul lors d'un cycle donné, car une seule rangée de la matrice de cellules mémoire est activée à chaque calcul. Selon les contextes applicatifs, la solution « un neurone par rangée » ou « un neurone par colonne » sera à privilégier, notamment en fonction du nombre d'entrées de chaque neurone, en fonction du nombre de neurones par couche, de la surface disponible, etc...

Il existe donc un besoin pour un circuit électronique permettant notamment de réaliser un réseau de neurones binaire qui soit moins encombrant et présente une meilleure intégrabilité dans un ensemble de cellules mémoire.

A cet effet, l'invention a pour objet un circuit électronique selon la revendication 1.

Avec le circuit électronique selon l'invention, le module de lecture comportant une unité logique pour chaque colonne et l'unité de modification apte à modifier, pour au moins une unité logique et en fonction de l'opération de calcul, la différence entre la valeur de colonne et la valeur de seuil, permet de déterminer plus efficacement une valeur résultante correspondant à la tension de la ligne de source respective.

De préférence, chaque cellule mémoire comporte deux paires de memristors et deux paires de commutateurs, avec une première paire de commutateurs reliée à une première ligne de mot assignée à une entrée, et respectivement une deuxième paire de commutateurs reliée à une deuxième ligne de mot assignée à l'inverse de ladite entrée ; et avec une première paire de memristors associée à la première paire de commutateurs et mémorisant un poids synaptique, et respectivement une deuxième paire de memristors associée à la deuxième paire de commutateurs et mémorisant l'inverse du même poids synaptique.

Selon cette implémentation astucieuse, chaque cellule mémoire permet alors d'effectuer directement une opération de non-ou-exclusif, ou XNOR, entre une entrée et le poids synaptique correspondant d'un neurone respectif, et une valeur d'inférence dudit neurone est alors obtenue directement à partir de la valeur résultante correspondant à la tension de la ligne de source respective, ou bien à partir des valeurs résultantes correspondant aux tensions des lignes de source respectives lorsque les poids synaptiques dudit neurone sont encodés sur plusieurs colonnes de l'ensemble de cellules mémoire en forme matrice.

Suivant d'autres aspects avantageux de l'invention, le circuit électronique est selon l'une quelconque des revendications 2 à 17.

Suivant d'autres aspects avantageux de l'invention, le circuit électronique comprend une ou plusieurs des caractéristiques suivantes, prises isolément ou suivant toutes les combinaisons techniquement possibles :

- chaque unité logique réalise une fonction logique de type inverseur ;
- chaque unité logique étant de préférence un simple inverseur ;

le simple inverseur comportant de préférence encore seulement deux transistors.

Ces caractéristiques et avantages de l'invention apparaîtront plus clairement à la lecture de la description qui va suivre, donnée uniquement à titre d'exemple non limitatif, et faite en référence aux dessins annexés, sur lesquels :

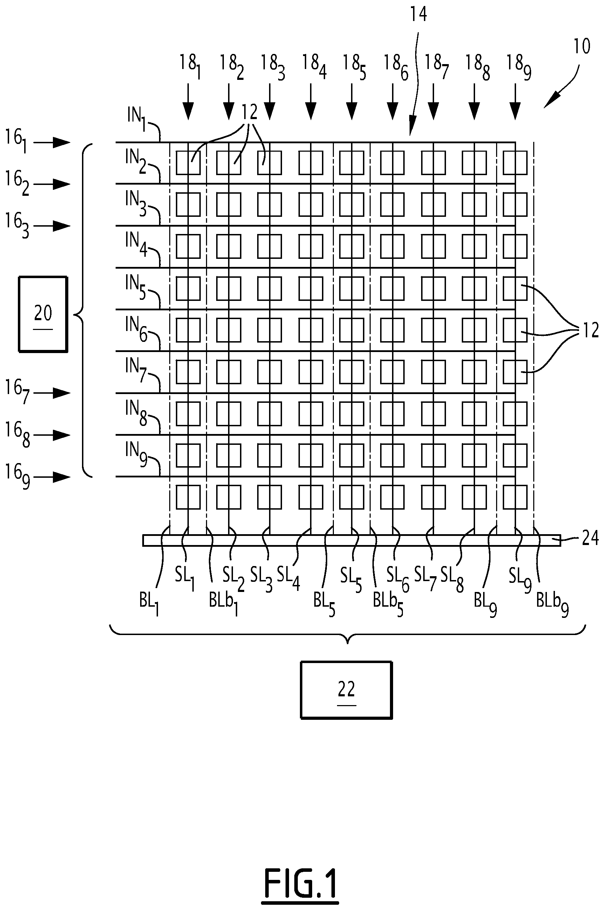

- la figure 1 est une représentation schématique d'un circuit électronique, selon l'invention, propre à mettre en œuvre des opérations de calcul fournissant chacune une sortie binaire, le circuit comprenant des lignes de mot, des paires de lignes de bit complémentaires, des lignes de source, un ensemble de cellules mémoire organisées selon une matrice comportant des rangées et des colonnes, chaque cellule mémoire comportant au moins une paire de memristors et au moins une paire de commutateurs, et un module de lecture mis en œuvre lors de chaque opération de calcul, le module de lecture comportant une unité logique pour chaque colonne, chaque unité logique effectuant une opération logique avec basculement entre une valeur basse et une valeur haute en fonction d'une comparaison d'une valeur de colonne par rapport à une valeur de seuil de basculement, et une unité de modification, pour au moins une unité logique et en fonction de l'opération de calcul, d'une différence entre la valeur de colonne et la valeur de seuil de basculement ;
- la figure 2 est une représentation schématique d'une cellule mémoire respective selon un premier exemple de réalisation, où elle comporte deux paires de memristors et deux paires de commutateurs ;
- la figure 3 est un graphe montrant l'effet de la variabilité des valeurs des résistances des états d'un memristor ;
- la figure 4 est une vue schématique illustrant une opération XNOR effectuée via la cellule mémoire de la figure 2 ;
- la figure 5 est une représentation schématique d'une unité logique respective de la figure 1, et de la tension en sortie de ladite unité logique en tenant compte de l'effet de variabilité représenté à la figure 3, pour un exemple à cinq rangées de cellules mémoire ;
- la figure 6 est une représentation schématique illustrant la modification, pour l'unité logique de la figure 5, de la différence entre la valeur de colonne et la valeur de seuil de basculement ;
- la figure 7 est une représentation du circuit électronique selon l'invention avec les cellules mémoire de la figure 2, dans un exemple où le circuit électronique forme un circuit neuromorphique mettant en œuvre un réseau de neurones à sortie binaire, chaque cellule mémoire étant associée à un poids synaptique respectif d'un neurone, et les lignes de mot étant aptes à recevoir des tensions d'entrée lors d'une opération de calcul neuronal ;
- la figure 8 est une représentation schématique du circuit électronique selon l'invention avec une implémentation particulière d'un contrôleur des paires de lignes de bit complémentaires, propre à réinitialiser une valeur de colonne respective après détection par l'unité logique d'un basculement pour ladite colonne ;
- la figure 9 est une représentation schématique du circuit électronique selon l'invention et d'un chronogramme associé, le circuit comportant en outre un registre en sortie de chaque unité logique, chaque registre étant propre à transcrire sous forme binaire le résultat de l'opération de calcul pour la colonne, en enregistrant - jusqu'à l'atteinte de la valeur résultante correspondant au résultat de l'opération de calcul - chaque valeur successive en sortie de l'unité logique correspondante, comme illustré sur le chronogramme ;
- la figure 10 est une représentation schématique d'une cellule mémoire respective selon un deuxième exemple de réalisation, où elle comporte une seule paire de memristors et une seule paire de commutateurs ;
- la figure 11 est une vue analogue à celle de la figure 5, représentant en outre des exemples de seuil de basculement, lorsque l'opération de calcul effectuée est l'opération ET logique, ou respectivement l'opération OU logique ; et
- la figure 12 est une représentation schématique du circuit électronique selon l'invention, le circuit comportant en outre une bascule en sortie de chaque unité logique, chaque bascule étant propre à réaliser une combinaison de résultats d'opérations logiques effectuées successivement par une unité logique respective, pour mettre en œuvre une opération logique combinée, telle qu'une opération de ou-exclusif ou une opération de non-ou-exclusif.

Il est à noter que l'expression « propre à » suivie d'un verbe est considérée équivalente à l'expression « configuré pour » suivie du même verbe. L'expression « propre à » sera alors au besoin remplaçable par l'expression « configuré pour », sans que cela ne modifie le contenu et la teneur de la présente invention.

Sur la figure 1, un circuit électronique 10 est propre à mettre en œuvre des opérations de calcul fournissant chacune une sortie binaire. Les opérations de calcul effectuées par le circuit électronique 10 sont par exemple des opérations de calcul neuronal, telles que des opérations de comptage du nombre de 1 dans une série de bits (de l'anglais *popcount*), voire des opérations MAC (de l'anglais *Multiply And Accumulate*) bien connues pour l'inférence des réseaux de neurones ; des opérations ET sur des opérandes binaires ; des opérations OU sur des opérandes binaires ; des opérations Majorité parmi des opérandes binaires.

Le circuit électronique 10 comprend un ensemble de cellules mémoire 12, c'est-à-dire une pluralité de cellules mémoire 12, les cellules mémoire 12 étant organisées selon une matrice 14 bidimensionnelle comportant des rangées 16 et des colonnes 18.

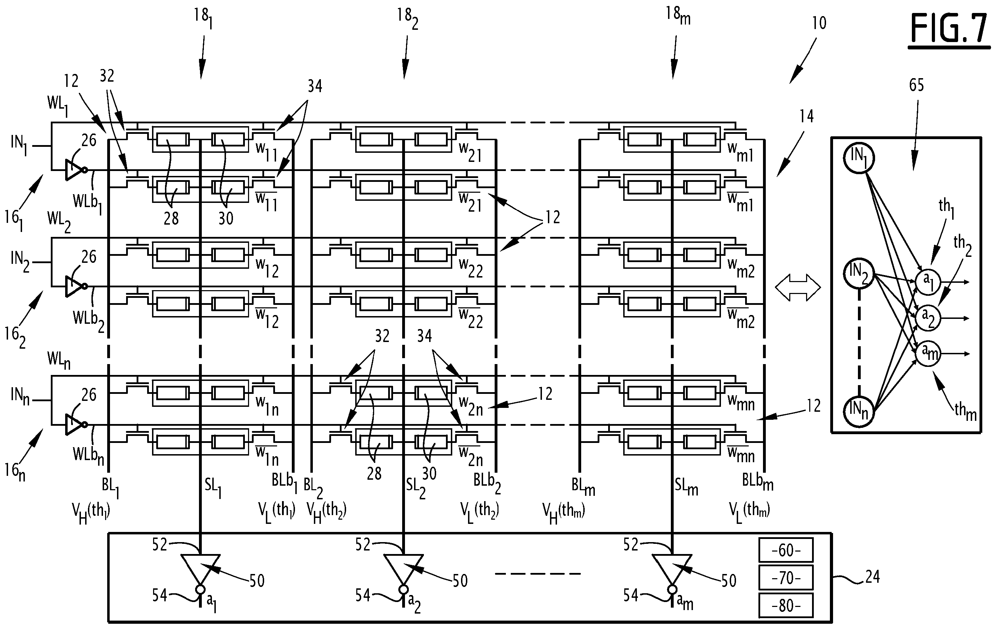

En complément, le circuit électronique 10 comporte plusieurs ensembles distincts de cellules mémoire 12 propres à fonctionner en parallèle, comme illustré notamment dans l'exemple de la figure 7.

La matrice 14 sera désignée sous le terme de matrice de cellules 14 dans la suite de la description. Une cellule mémoire 12 a les coordonnées (i,j) lorsque ladite cellule mémoire 12 est positionnée au croisement de la i-ième rangée $16_i$ et de la j-ième colonne $18_j$ avec i et j deux entiers.

Dans l'exemple de la figure 1, le nombre de rangées 16 et de colonnes 18 est égal à N, de sorte que les indices i et j sont compris entre 1 et N. Dans l'exemple de la figure 1, il a été représenté une matrice de cellules 14 pour laquelle N est égal à 9. En variante, le nombre de rangées 16 et de colonnes 18 peut bien entendu être différent.

Plus généralement, dans l'exemple de la figure 7, le nombre de rangées 16 est égal à n et respectivement le nombre de colonnes 18 est égal à m, de sorte que l'indice i est compris entre 1 et n, et respectivement l'indice j est compris entre 1 et m.

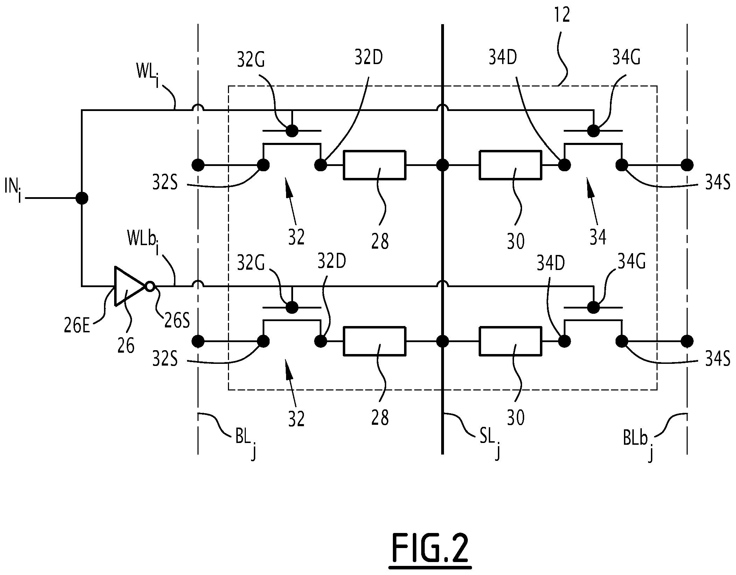

Le circuit électronique 10 comprend également des lignes de mot WL (visibles sur les figures 2, 7 et 10), des paires de lignes de bit complémentaires BL et BLb, des lignes de source SL et deux contrôleurs 20 et 22.

Le circuit électronique 10 comprend également un module de lecture 24 mis en œuvre lors de chaque opération de calcul, qui sera décrit plus en détail dans la suite de la description.

Dans les notations précédentes, une ligne de mot est référencée WL (de l'anglais *Word Line*) ; les lignes de bit complémentaires BL et BLb utilisent le sigle BL (de l'anglais *Bit Line*) et les lignes de source sont référencées avec le sigle SL (de l'anglais *Source Line*).

Dans l'exemple de la figure 1, chaque cellule mémoire 12 est connectée à une ligne d'entrée IN respective, une ligne de source SL respective et une paire respective de lignes de bit complémentaires BL et BLb.

Chaque ligne d'entrée IN est propre à recevoir ou à sélectionner un opérande auquel l'opération de calcul est à appliquer. Chaque ligne d'entrée IN est par exemple propre à recevoir une valeur d'entrée pour l'opération de calcul.

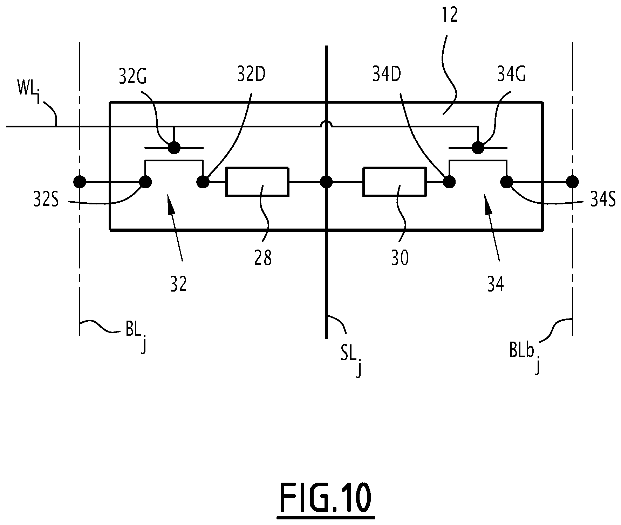

Chaque ligne d'entrée IN est elle-même connectée à une ligne de mot WL respective ou bien à une paire respective de lignes de mot complémentaires WL et WLb, en fonction de la topologie des cellules mémoire 12. Dans les exemples des figures 2, 4 et 7, chaque ligne d'entrée IN est connectée à une paire respective de lignes de mot complémentaires WL et WLb. Dans l'exemple de la figure 10, chaque ligne d'entrée IN est connectée à une seule ligne de mot WL respective.

Chaque cellule mémoire 12 d'une même rangée 16 partage la même ligne d'entrée IN, elle-même connectée à une ligne de mot WL respective ou bien à une paire respective de lignes de mot complémentaires WL et WLb, de sorte que les lignes d'entrée IN, et respectivement les lignes de mot WL, WLb, peuvent également être indexées avec l'indice i. Ainsi, la première ligne d'entrée IN, c'est-à-dire celle qui relie les cellules mémoire 12 de la première rangée 16, est référencée $IN_1$ ; et la, ou respectivement les, ligne(s) de mot associée(s) à cette première ligne d'entrée $IN_1$ sont référencées $WL_1$, ou respectivement $WL_1$ et $WLb_1$.

Les cellules mémoire 12 d'une même colonne 18 partagent la même paire de lignes de bit complémentaires BL et BLb et la même ligne de source SL. Ces trois lignes peuvent donc également être indexées avec l'indice j.

Dans un souci de clarté, l'ensemble des lignes de source SL sont représentées mais seules les paires de lignes de bit complémentaires BL et BLb de la première colonne $18_1$, de la cinquième colonne $18_5$ et de la neuvième colonne $18_9$ sont représentées en traits mixtes sur la figure 1.

Les cellules mémoire 12 d'une même rangée 16 sont alors sélectionnables par au moins une ligne de mot WL, et les cellules mémoire 12 d'une même colonne 18 sont reliées à une paire de lignes de bit complémentaires BL, BLb et une ligne de source SL.

Le premier contrôleur 20 permet de sélectionner les cellules mémoire 12 d'une rangée 16 qui sont reliées à une même ligne de mot WL.

Le premier contrôleur 20 est propre à contrôler chaque ligne d'entrée IN, et par transitivité chaque ligne de mot WL, WLb. En effet, lorsque chaque ligne d'entrée IN est connectée à une paire respective de lignes de mot complémentaires WL et WLb, la ligne d'entrée IN est connectée directement à l'une WL des lignes de mot, et via un inverseur 26, appelé par la suite inverseur 26 de ligne de mot, à l'autre WLb des lignes de mot ; et le contrôle de la valeur appliquée à la ligne d'entrée IN entraîne également le contrôle de la valeur appliquée à la paire respective de lignes de mot complémentaires WL et WLb. En effet, l'homme du métier comprendra bien entendu que la valeur appliquée à la ligne d'entrée IN est alors la même que celle appliquée à la ligne de mot WL qui est connectée directement à la ligne d'entrée IN, et de manière corollaire que la valeur appliquée à la ligne d'entrée IN est alors l'inverse de celle qui est appliquée à la ligne de mot complémentaire WLb qui est connectée à la ligne d'entrée IN par l'intermédiaire de l'inverseur 26 de ligne de mot. Bien entendu, lorsque chaque ligne d'entrée IN est connectée directement à une seule ligne de mot WL respective, comme dans l'exemple de la figure 10, alors la valeur appliquée à la ligne d'entrée IN est la même que celle appliquée à ladite ligne de mot WL connectée directement à la ligne d'entrée IN.

Par « inverse » d'une valeur binaire, on entend la valeur complémentaire à 1 de ladite valeur binaire. Autrement dit, si une valeur binaire est égale à 0, l'inverse de cette valeur binaire est égal à 1 ; et respectivement si une valeur binaire est égale à 1, l'inverse de cette valeur binaire est égal à 0.

Le deuxième contrôleur 22 est propre à contrôler les paires de lignes de bit complémentaires BL et BLb et les lignes de source SL.

Le deuxième contrôleur 22 est relié aux paires de lignes de bit BL, BLb et permet d'appliquer sur chaque paire de ligne de bit BL, BLb des tensions différentes, les tensions appliquées lors de l'opération de calcul étant avantageusement symétriques par rapport à une tension milieu, la tension appliquée sur une ligne de bit BL étant supérieure ou inférieure à celle appliquée sur la ligne de bit complémentaire BLb associée.

Le premier contrôleur 20 et le deuxième contrôleur 22 sont configurés pour être pilotés de manière coordonnée pour commander les cellules mémoire 12 à l'aide des lignes qu'ils contrôlent selon le fonctionnement souhaité.

En particulier, le premier contrôleur 20 est configuré pour amener les valeurs d'entrées circulant sur chacune des lignes d'entrée IN. Ce sont ces valeurs d'entrées qui viendront par exemple alimenter le réseau de neurones réalisé le cas échéant par le circuit électronique 10.

L'inverseur 26 est un élément propre à recevoir un signal incident sur une entrée 26E et effectuer un calcul d'inversion logique pour émettre sur une sortie 26S un signal de sortie qui est l'inverse du signal incident. Ici, l'entrée 26E de l'inverseur 26 est connectée à la ligne d'entrée IN, et la sortie 26S de l'inverseur 26 est connectée à la ligne de mot complémentaire WLb.

Chaque cellule mémoire 12 est propre à mémoriser au moins une valeur binaire, telle qu'un poids binaire, en particulier un poids synaptique binaire respectif du réseau de neurones lorsque l'opération de calcul effectuée est une opération de calcul neuronal.

La structure d'une cellule mémoire 12 est représentée plus précisément sur la figure 2 pour le cas de la cellule mémoire 12 ayant les coordonnées (i,j).

Chaque cellule mémoire 12 comporte au moins une paire de memristors 28, 30, la ou chaque paire de memristors étant formée de deux memristors, à savoir un premier memristor 28 et un deuxième memristor 30, et au moins une paire de commutateurs 32, 34, la ou chaque paire de commutateurs étant formée de deux commutateurs, à savoir un premier commutateur 32 et un deuxième commutateur 34.

Dans les exemples des figures 2, 4 et 7, chaque cellule mémoire 12 comporte deux paires de memristors 28, 30, c'est-à-dire deux premiers memristors 28 et deux deuxièmes memristors 30, et deux paires de commutateurs 32, 34, c'est-à-dire deux premiers commutateurs 32 et deux deuxièmes commutateurs 34.

Dans l'exemple de la figure 10, chaque cellule mémoire 12 comporte une seule paire de memristors 28, 30, c'est-à-dire un seul premier memristor 28 et un seul deuxième memristor 30, et une seule paire de commutateurs 32, 34, c'est-à-dire un seul premier commutateur 32 et un seul deuxième commutateur 34.

Du fait que des memristors 28 et 30 sont présents, une telle cellule mémoire 12 est une cellule de mémoire résistive à accès aléatoire. La cellule mémoire 12 est plus souvent désigné par l'acronyme RRAM ou ReRAM (de l'anglais *Resistive random-access memory*).

En outre, un tel agencement est généralement appelé structure 4T4R en référence à la présence des quatre commutateurs (appellation 4T) et de quatre memristors (appellation 4R) dans les exemples des figures 2, 4 et 7. Par analogie, un tel agencement est généralement appelé structure 2T2R en référence à la présence des deux commutateurs (appellation 2T) et de deux memristors (appellation 2R) dans l'exemple de la figure 10. La cellule mémoire 12 est aussi parfois dénommée cellule 4T4R dans les exemples des figures 2, 4 et 7, ou respectivement cellule 2T2R dans l'exemple de la figure 10.

Chaque memristor 28, 30 d'une cellule mémoire 12 respective est relié à la même ligne de source SL et à un commutateur 32, 34 respectif, et chaque paire de memristors 28, 30 est configurée pour mémoriser respectivement une valeur binaire en présentant respectivement des première et deuxième valeurs de résistances différentes. L'homme du métier observera que la ligne de source SL auxquels sont reliés les memristors 28, 30 de la cellule mémoire 12 respective est susceptible d'être formée de deux lignes de source distinctes connectées entre elles pendant l'opération de calcul.

Chaque memristor 28, 30 est un composant dont la valeur de sa résistance électrique change, de façon permanente, lorsqu'un courant est appliqué. Ainsi, une donnée peut être enregistrée et réécrite par un courant de contrôle. Un tel comportement est notamment observé dans les matériaux à changement de phase, les jonctions tunnel ferroélectriques ou les mémoires redox à base d'oxydes, tels que le $HfO_x$ ou $TiO_{2-x}$. Le changement de résistance d'un memristor dépend de l'amplitude et de la durée des impulsions de tension appliquées à travers le memristor, ainsi que de la valeur maximale de courant pouvant passer dans le memristor par exemple pour une opération de « SET », c'est-à-dire le passage d'une résistance forte à une résistance faible.

Chaque memristor 28, 30 présente ainsi deux états, à savoir un état haut et un état bas. L'état haut correspond à une forte résistance et est généralement désigné par l'abréviation HRS. L'état haut est, de ce fait, dénommé état haut HRS dans la suite. L'état bas correspond à une faible résistance et est généralement désigné par l'abréviation LRS. L'état bas est, de ce fait, dénommé état bas LRS dans la suite.

Toutefois, du fait de la variabilité des memristors 28, 30 en fonctionnement, il se trouve que la résistance dans l'état haut HRS peut être inférieure à la résistance dans l'état bas LRS, ce qui génère des erreurs si l'information (poids) est codée dans un seul memristor 28, 30.

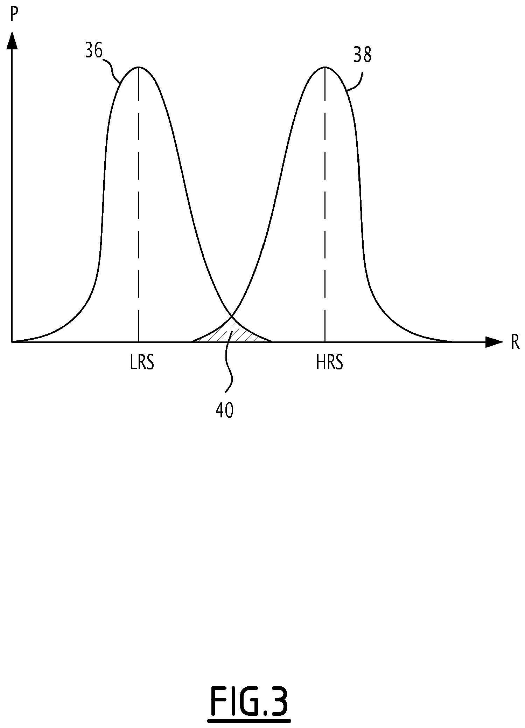

Cette variabilité est présentée schématiquement sur la figure 3. Dans cette figure, il est proposé la probabilité qu'un memristor 28, 30 présente en pratique la valeur de résistance en fonction de l'état du memristor. Plus précisément, la première courbe, la courbe notée 36, représente schématiquement la probabilité pour l'ensemble des valeurs observées en pratique pour l'état bas LRS tandis que la deuxième courbe 38 représente la même courbe pour l'état haut HRS.

Le graphe de la figure 3 montre qu'il existe une zone de recouvrement 40. Dans cette zone de recouvrement 40, distinguer les états bas LRS et haut HRS peut être impossible. Ce recouvrement peut être plus important avec les dérives temporelles à long terme des memristors 28, 30.

Pour remédier à ce problème, l'information est codée par le rapport entre les deux résistances des deux états grâce à une configuration en différentiel des deux memristors 28 et 30. Aussi, les memristors 28 et 30 sont des memristors en série et complémentaires respectant le même codage logique. Par complémentaire, il est ici entendu que les memristors 28 et 30 présentent un état différent, un état bas LRS pour l'un et un état haut HRS pour l'autre.

Selon les exemples des figures 2, 4, 7 et 10, un poids fort, c'est-à-dire un « 1 » logique, est représenté par un état haut HRS du premier memristor 28, et respectivement un état bas LRS du deuxième memristor 30. De manière corollaire, un poids faible, c'est-à-dire un « 0 » logique, est représenté par un état bas LRS du premier memristor 28, et respectivement un état haut HRS du deuxième memristor 30.

En outre, dans les exemples des figures 2, 4 et 7 où chaque cellule mémoire 12 comporte deux paires de memristors 28, 30, les paires de memristors 28, 30 sont de préférence codées de manière complémentaire d'une paire à l'autre. Autrement dit, au sein de chaque cellule mémoire 12, une paire de memristors 28, 30 est de préférence configurée pour coder une valeur binaire, pendant que l'autre paire de memristors 28, 30 est de préférence configurée pour coder l'inverse de ladite valeur binaire.

Aussi, dans l'exemple de logique de codage précitée, si la valeur binaire à encoder est égale à 1 pour la première paire de memristors 28, 30, le memristor de gauche, i.e. le premier memristor 28, est codé en forte résistance (état haut HRS), et le memristor de droite, i.e. le deuxième memristor 30, est codé en faible résistance (état bas LRS), tandis que pour la deuxième paire de memristors 28, 30 encodant l'inverse de ladite valeur binaire, soit 0, le memristor de gauche, i.e. i.e. le premier memristor 28, est codé en faible résistance (état bas LRS) et le memristor de droite, i.e. le deuxième memristor 30, est codé en forte résistance (état haut HRS).

Une première paire de commutateurs 32, 34 est reliée à une première ligne de mot assignée à une entrée IN, à savoir la ligne de mot WL connectée directement la ligne d'entrée IN, et respectivement une deuxième paire de commutateurs 34, 32 est reliée à une deuxième ligne de mot assignée à l'inverse de ladite entrée IN, à savoir la ligne de mot complémentaire WLb connectée la ligne d'entrée IN via l'inverseur 26 de ligne de mot. La première paire de memristors 28, 30 est associée à la première paire de commutateurs 32, 34 et mémorise une valeur binaire w ; et respectivement la deuxième paire de memristors 28, 30 est associée à la deuxième paire de commutateurs 34, 32 et mémorise l'inverse de la même valeur binaire w.

En outre, comme décrit précédemment, la première paire de memristors 28, 30 et la première paire associée de commutateurs 32, 34 verront leur ligne de mot WL assignée à l'entrée correspondant à la valeur binaire, tandis que la deuxième paire de memristors 28, 30 et la deuxième paire associée de commutateurs 32, 34 verront leur ligne de mot complémentaire WLb assignée à l'inverse de la même entrée, de par l'inverseur 26 de ligne de mot.

Les commutateurs 32, 34 sont reliés, pour leur activation, à une ligne de mot WL, WLb respective et reliés respectivement à une paire de lignes de bit complémentaires BL, BLb, les deux commutateurs 32, 34 d'une paire respective étant reliés à une même ligne de mot WL, WLb.

Chacun des deux commutateurs 32 et 34 est par exemple un transistor, tel qu'un transistor à effet de champ, également appelé FET (de l'anglais *Field-Effect Transistor*).

Ainsi, chaque commutateur 32 et 34 présente trois électrodes, une grille G, une source S et un drain D. De manière générale, pour un transistor dont le signe de référence est X, où X désigne la référence 32 ou 34, les électrodes seront notées sur les figures selon la notation suivante : la grille XG, la source XS et le drain XD.

Cette notation est choisie ici pour simplifier la représentation, sachant que les positions de la source XS et du drain XD sont définies par rapport au sens de polarisation principal, c'est-à-dire le plus usité pour le montage. Bien entendu, si la polarisation est inversée, l'homme du métier sait que les rôles et les positions de la source XS et du drain XD sont échangés.

Selon l'exemple décrit, les deux commutateurs 32 et 34 sont des transistors à effet de champ à grille isolée, également appelés MOSFET (de l'anglais *Metal Oxide Semiconductor Field Effect Transistor*).

Chaque grille 32G et 34G des deux commutateurs 32 et 34 est connectée à la ligne de mot WL. Selon le niveau de tension présent sur la ligne de mot, les commutateurs 32 et 34 sont rendus passants ou au contraire non-passants, i.e. bloqués. Le premier contrôleur 20 va en pratique choisir de sélectionner une ou plusieurs rangées 16 de cellules mémoire 12 en rendant conducteurs les commutateurs 32, 34 des cellules mémoire 12 de cette ou ces rangées 16.

Chaque premier commutateur 32 est connecté à un premier memristor 28 respectif, et chaque deuxième commutateur 34 est connecté à un deuxième memristor 30 respectif. Le drain 32D du premier commutateur 32 est alors relié à une borne du premier memristor 28, l'autre borne du premier memristor 28 étant reliée à la ligne de source SL commune. Le drain 34D du deuxième commutateur 34 est relié à une borne du deuxième memristor 30, l'autre borne du deuxième memristor 30 étant reliée à la ligne de source SL commune. La source 32S du premier commutateur 32 est reliée à la ligne de bit BL tandis que la source 34S du deuxième commutateur 34 est reliée à la ligne de bit complémentaire BLb.

Le second contrôleur 22 va piloter l'alimentation des paires de lignes de bit, de sorte à ce que la tension présentée sur une ligne de bit $BL_j$ soit différente et complémentaire de la tension présentée sur la ligne de bit complémentaire $BLb_j$. Ainsi, quand une cellule mémoire 12 de coordonnée i,j, en particulier une paire de memristors 28, 30, est sélectionnée (ses commutateurs étant rendus passants par la tension d'activation présentée sur la ligne de mot $WL_i$ ou $WLb_i$ associée), les memristors 28 et 30 de cette paire sont en série et constituent un pont résistif entre les lignes de bit $BL_j$ et $BLb_j$.

Dans le cas d'espèce, les memristors 28 et 30 de cette paire sont ainsi alimentés par des tensions présentes sur les lignes de bit $BL_j$ et $BLb_j$ symétriques par rapport à une tension égale à [V(BL)+V(BLb)]/2, dite tension milieu, où V(BL) représente la tension de la ligne de bit BL, et V(BLb) représente la tension de la ligne de bit complémentaire BLb.

Dans les exemples des figures 2, 4 et 7, avec la logique de codage définie ci-dessus, si la valeur binaire, tel qu'un poids, en particulier un poids synaptique d'un réseau de neurones binaire, stockée dans une cellule mémoire 12 donnée est égale à 0, alors pour la première paire de memristors 28, 30, le premier memristor 28 (correspondant à celui en haut à gauche parmi les quatre memristors de la cellule mémoire 12) est l'état bas LRS et le deuxième memristor 30 (correspondant à celui en haut à droite) est à l'état haut HRS ; et inversement, pour la deuxième paire de memristors 28, 30, le premier memristor 28 (correspondant à celui en bas à gauche) est à l'état haut HRS et le deuxième memristor 30 (correspondant à celui en bas à droite) est à l'état bas LRS.

L'homme du métier comprendra bien entendu que le codage est inversé si la valeur binaire stockée dans la cellule mémoire 12 est égale à 1, et pour la première paire de memristors 28, 30, le premier memristor 28 (correspondant à celui en haut à gauche) est l'état haut HRS et le deuxième memristor 30 (correspondant à celui en haut à droite) est à l'état bas LRS ; et inversement, pour la deuxième paire de memristors 28, 30, le premier memristor 28 (correspondant à celui en bas à gauche) est à l'état bas LRS et le deuxième memristor 30 (correspondant à celui en bas à droite) est l'état haut HRS.

L'homme du métier observera en outre que dans les exemples des figures 2, 4 et 7 et de par l'inverseur 26 de ligne de mot, une seule paire de memristors 28, 30 parmi les deux paires de memristors 28, 30 est activable à la fois. En particulier, dans ces exemples, et étant donné que l'inverseur 26 de ligne de mot est connecté à la ligne de mot complémentaire WLb associée à la deuxième paire de memristors 28, 30, si la valeur d'entrée reçue sur la ligne d'entrée IN est égale à 1, alors la première paire de memristors 28, 30 est activée puisque la valeur sur la ligne de mot WL connectée directement la ligne d'entrée IN est aussi égale à 1 et que les commutateurs 32, 34 associés à cette première paire sont donc passants, tandis que la deuxième paire de memristors 28, 30 n'est pas activée puisque la valeur sur la ligne de mot complémentaire WLb est alors égale à 0, l'inverseur 26 de ligne de mot inversant la valeur d'entrée égale à 1 en la valeur 0, et que les commutateurs 32, 34 associés à cette deuxième paire sont donc non-passants, i.e. bloqués. Inversement, si la valeur d'entrée reçue sur la ligne d'entrée IN est égale à 0, alors la première paire de memristors 28, 30 n'est pas activée puisque la valeur sur la ligne de mot WL est aussi égale à 0 et que les commutateurs 32, 34 associés à cette première paire sont donc non-passants, tandis que la deuxième paire de memristors 28, 30 est dans ce cas activée puisque la valeur sur la ligne de mot complémentaire WLb est alors égale à 1, l'inverseur 26 de ligne de mot inversant la valeur d'entrée égale à 0 en la valeur 1, et que les commutateurs 32, 34 associés à cette deuxième paire sont donc passants.

En outre, lorsqu'une tension est appliquée entre la ligne de bit BL et la ligne de bit complémentaire BLb, avec un potentiel plus haut $V_H$ pour la ligne de bit BL que celui $V_L$ pour la ligne de bit complémentaire BLb, cela résulte en un pont résistif entre les premier et deuxième memristors 28, 30 de la paire de memristors 28, 30 qui est activée, comme expliqué précédemment. Le memristor 28, 30 qui est à l'état haut HRS repousse alors systématiquement la tension du point milieu, i.e. celle de la ligne de source SL, vers la ligne de bit BL, BLb qui est connectée au memristor 28, 30 à l'état bas LRS.

Aussi, dans les exemples des figures 2, 4 et 7, avec cette implémentation astucieuse des deux paires de memristors 28, 30 couplées aux deux lignes de mot complémentaires WL, WLb, l'une des lignes de mot étant connectée à la ligne d'entrée IN via l'inverseur 26 de ligne de mot, chaque cellule mémoire 12 permet alors d'effectuer directement une opération de non-ou-exclusif, ou XNOR, entre l'entrée binaire reçue sur la ligne d'entrée IN et la valeur binaire, telle que le poids synaptique correspondant d'un neurone respectif, stockée dans la cellule mémoire 12, et le résultat de l'opération XNOR est alors obtenu via la comparaison de la tension de la ligne de source SL avec la tension milieu.

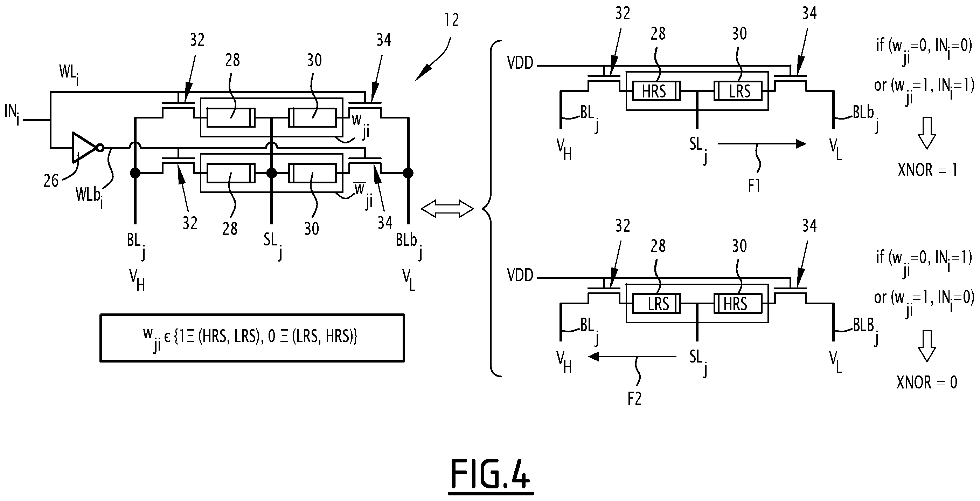

Dans l'exemple de la figure 4, avec la logique de codage définie ci-dessus, si la tension de la ligne de source SL est inférieure à la tension milieu [V(BL)+V(BLb)]/2, alors le résultat de l'opération XNOR est égal à 1 ; si la tension de la ligne de source SL est supérieure à la tension milieu [V(BL)+V(BLb)]/2, alors le résultat de l'opération XNOR est égal à 0.

Les quatre situations possibles selon que la valeur d'entrée binaire, également appelée entrée binaire, reçue sur la ligne d'entrée $IN_i$ est égale à 0 ou 1, et est selon que la valeur binaire $w_{ji}$ stockée dans la cellule mémoire 12 est égale à 0 ou 1, sont alors représentées de manière synthétique sur la partie droite de la figure 4.

Dans la première situation où l'entrée binaire reçue sur la ligne d'entrée $IN_i$ est égale à 0 et la valeur binaire $w_{ji}$ stockée dans la cellule mémoire 12 est égale à 0, la deuxième paire de memristors 28, 30 est activée, et le premier memristor 28 (correspondant à celui à gauche) est à l'état haut HRS pendant que le deuxième memristor 30 (correspondant à celui à droite) est l'état bas LRS. Le premier memristor 28 à l'état haut HRS repousse alors la tension de la ligne de source $SL_j$ vers la ligne de bit complémentaire $BLb_j$ connectée au deuxième memristor 30 à l'état bas LRS, comme représenté par la flèche F1. La tension de la ligne de source $SL_j$ est alors plus proche du potentiel bas $V_L$ pour la ligne de bit complémentaire $BLb_j$ que du potentiel haut $V_H$ de la ligne de bit $BL_j$, et est donc inférieure à la tension milieu [V(BL)+V(BLb)]/2, si bien que le résultat de l'opération XNOR est égal à 1. Ceci vérifie donc bien XNOR(0,0) = 1.

Dans la deuxième situation où l'entrée binaire reçue sur la ligne d'entrée $IN_i$ est égale à 1 et la valeur binaire $w_{ji}$ stockée dans la cellule mémoire 12 est égale à 1, la première paire de memristors 28, 30 est activée, et le premier memristor 28 (correspondant à celui à gauche) est l'état haut HRS, le deuxième memristor 30 (correspondant à celui à droite) étant à l'état bas LRS. Le premier memristor 28 à l'état haut HRS repousse alors la tension de la ligne de source $SL_j$ vers la ligne de bit complémentaire $BLb_j$ connectée au deuxième memristor 30 à l'état bas LRS, comme représenté par la flèche F1. La tension de la ligne de source $SL_j$ est alors inférieure à la tension milieu [V(BL)+V(BLb)]/2, et le résultat de l'opération XNOR est donc égal à 1. Ceci vérifie donc bien XNOR(1,1) = 1.

Dans la troisième situation où l'entrée binaire reçue sur la ligne d'entrée $IN_i$ est égale à 1 et la valeur binaire $w_{ji}$ stockée dans la cellule mémoire 12 est égale à 0, la première paire de memristors 28, 30 est activée, et le premier memristor 28 (correspondant à celui à gauche) est l'état bas LRS, pendant que le deuxième memristor 30 (correspondant à celui à droite) est à l'état haut HRS. Le deuxième memristor 30 à l'état haut HRS repousse alors la tension de la ligne de source $SL_j$ vers la ligne de bit $BL_j$ connectée au premier memristor 28 à l'état bas LRS, comme représenté par la flèche F2. La tension de la ligne de source $SL_j$ est alors plus proche du potentiel haut $V_H$ de la ligne de bit $BL_j$ que du potentiel bas $V_L$ pour la ligne de bit complémentaire $BLb_j$, et est donc supérieure à la tension milieu [V(BL)+V(BLb)]/2, si bien que le résultat de l'opération XNOR est égal à 0. Ceci vérifie donc bien XNOR(1,0) = 0.

Dans la quatrième et dernière situation où l'entrée binaire reçue sur la ligne d'entrée $IN_i$ est égale à 0 et la valeur binaire $w_{ji}$ stockée dans la cellule mémoire 12 est égale à 1, la deuxième paire de memristors 28, 30 est activée, et le premier memristor 28 (correspondant à celui à gauche) est à l'état bas LRS, pendant que le deuxième memristor 30 (correspondant à celui à droite) est l'état haut HRS. Le deuxième memristor 30 à l'état haut HRS repousse alors la tension de la ligne de source $SL_j$ vers la ligne de bit $BL_j$ connectée au premier memristor 28 à l'état bas LRS, comme représenté par la flèche F2. La tension de la ligne de source $SL_j$ est alors supérieure à la tension milieu [V(BL)+V(BLb)]/2, et le résultat de l'opération XNOR est donc égal à 0. Ceci vérifie donc bien XNOR(0,1) = 0.

L'homme du métier comprendra bien entendu qu'également avec une logique de codage inversée où la valeur binaire 1 stockée dans la cellule mémoire 12 est encodée sous la forme du premier memristor 28 à l'état bas LRS et du deuxième memristor 30 à l'état haut HRS, et de manière corollaire la valeur binaire 0 est encodée sous la forme du premier memristor 28 à l'état haut HRS et du deuxième memristor 30 à l'état bas LRS, chaque cellule mémoire 12 des exemples des figures 2, 4 et 7 permet toujours d'effectuer l'opération XNOR, et que le résultat de l'opération XNOR est alors égal à 0 si la tension de la ligne de source SL est inférieure à la tension milieu [V(BL)+V(BLb)]/2, et inversement égale à 1 si la tension de la ligne de source SL est supérieure à la tension milieu [V(BL)+V(BLb)]/2, ceci toujours dans l'hypothèse où le potentiel haut $V_H$ est appliqué à la ligne de bit BL, pendant que le potentiel bas $V_L$ est appliqué à la ligne de bit complémentaire BLb.

Bien entendu, dans l'hypothèse où les potentiels seraient appliqués aux lignes de bit complémentaires BL, BLb de manière inversée par rapport à ce qui précède, avec le potentiel haut $V_H$ appliqué à la ligne de bit complémentaire BLb et le potentiel bas $V_L$ appliqué à la ligne de bit BL, alors la logique de comparaison de la tension de la ligne de source SL avec la tension milieu pour déterminer le résultat de l'opération XNOR serait également inversée.

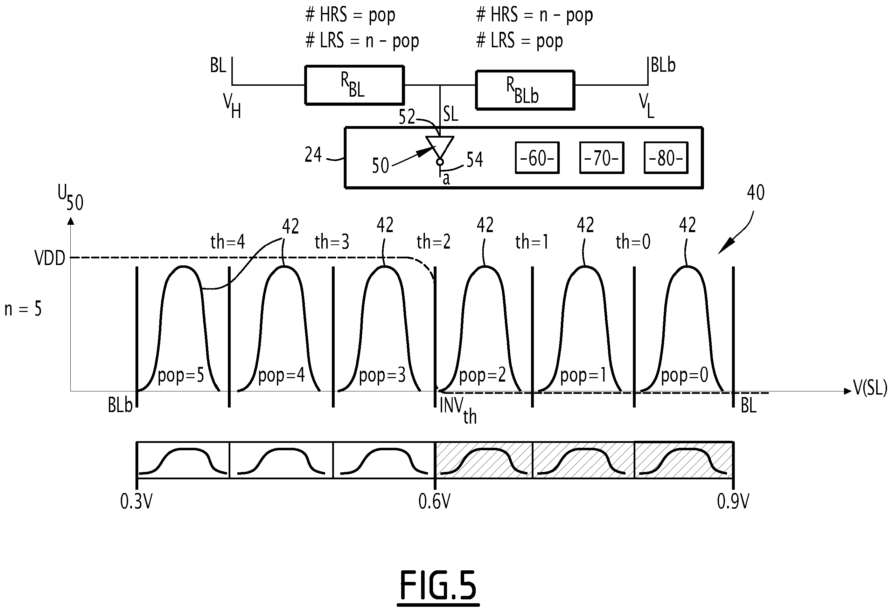

La figure 5 concerne alors les distributions de tensions obtenues au global sur la ligne de source $SL_j$, c'est-à-dire au bas de la ligne de source $SL_j$ dans les exemples des figures 1 et 7, lorsque plusieurs lignes d'entrée $IN_i$ sont utilisées simultanément, le graphe des distributions de tensions représenté à la figure 5 illustrant le cas où cinq lignes d'entrée $IN_i$ sont utilisées simultanément.

Cet exemple de la figure 5 concernent notamment le cas de l'inférence d'un réseau de neurones binaire. Pour bien comprendre ce qui va suivre, il peut être observé qu'un réseau de neurones binaire présente une spécificité dans l'inférence par rapport à un réseau de neurones classique.

Quand un réseau de neurones classique est appliqué sur un vecteur d'entrée pour calculer un vecteur de sortie, chaque neurone reçoit des valeurs d'entrée correspondant à des valeurs de sortie des neurones d'une couche précédente $a_j$ et réalise une somme pondérée $\Sigma_j W_{ij} \cdot a_j$ et le neurone applique ensuite une fonction non-linéaire $f$ au résultat de la somme pondérée.

Par contraste, dans un réseau de neurones binaire, la somme pondérée est obtenue en réalisant l'opération suivante :

[1]

$$a_j = sign\left[popcount_i\left(XNOR(w_{ji}, x_i)\right) - T_j\right]$$

où $a_j$ représente la valeur de sortie calculée par le neurone,

$x_i$ représentent les valeurs d'entrée pour ledit neurone,

$w_{ji}$ représentent les poids binaires respectifs associés audit neurone pour chacune des entrées ;

$XNOR$ est l'opération logique de non-ou-exclusif ;

$popcount_i$ est la fonction qui compte le nombre de 1 dans une série de bits, lorsque i varie entre 1 et le nombre n d'entrées ;

$T_j$ est un seuil prédéfini, et

$sign$ est une fonction associant la valeur 1 à une entrée positive et associant -1 à une valeur négative.

Lorsque les valeurs d'entrée sont appliquées sur les n lignes d'entrée $IN_i$, où n représente le nombre de lignes d'entrée $IN_i$, n lignes de mot sont activées parmi les 2n lignes de mot complémentaires $WL_i$, $WLb_i$. Cela forme alors un pont diviseur entre la ligne de bit $BL_j$ et la ligne de bit complémentaire $BLb_j$, comme représenté en partie supérieure de la figure 5, où une première résistance équivalente $R_{BL}$ correspond à la résistance équivalente pour la portion de pont diviseur connectée entre la ligne de bit $BL_j$ et la ligne de source $SL_j$, et une deuxième résistance équivalente $R_{BLb}$ correspond à la résistance équivalente pour la portion de pont diviseur connectée entre la ligne de bit complémentaire $BLb_j$ et la ligne de source $SL_j$.

D'après ce qui précède, notamment au vu de l'exemple de la figure 4, si le résultat de l'opération XNOR est égal à 1, alors le premier memristor 28 à gauche de la ligne de source $SL_j$ est à l'état haut HRS et le deuxième memristor 30 à droite de la ligne de source $SL_j$ est à l'état bas LRS. Inversement, si le résultat de l'opération XNOR est égal à 0, alors le premier memristor 28 à gauche de la ligne de source $SL_j$ est à l'état bas LRS et le deuxième memristor 30 à droite de la ligne de source $SL_j$ est à l'état haut HRS.

Pour la première résistance équivalente $R_{BL}$ correspondant à la portion de pont diviseur à gauche de la ligne de source $SL_j$, le nombre de memristors à l'état haut HRS, noté #HRS sur la figure 5, est alors égal à pop, où pop est égal au résultat de la fonction *popcount* dans l'équation (1) précédente lorsque les valeurs d'entrée $x_i$ sont les valeurs d'entrée appliquées sur les n lignes d'entrée $IN_i$, et pour la première résistance équivalente $R_{BL}$ le nombre de memristors à l'état bas LRS, noté #LRS sur la figure 5, est alors égal à n-pop, n représentant le nombre de lignes d'entrée $IN_i$.

Dans l'exemple de la figure 5, la première résistance équivalente $R_{BL}$ vérifie alors l'équation suivante :

[2]

$$\frac{1}{R_{BL}} = \frac{pop}{HRS} + \frac{n - pop}{LRS} = \frac{pL + H(n - p)}{HL} = \frac{p(L - H) + nH}{HL}$$

où $R_{BL}$ représente la première résistance équivalente,

pop, ou encore la notation abrégée p, est égal au résultat de la fonction *popcount* de l'équation (1) précédente,

n représentant le nombre de lignes d'entrée $IN_i$,

HRS, ou encore la notation abrégée H, représente la résistance du memristor 28, 30 à l'état haut HRS, et

LRS, ou encore la notation abrégée L, représente la résistance du memristor 28, 30 à l'état bas LRS.

De manière corollaire, pour la deuxième résistance équivalente $R_{BLb}$ correspondant à la portion de pont diviseur à droite de la ligne de source $SL_j$, le nombre #LRS de memristors à l'état bas LRS est alors égal à pop, le nombre #HRS de memristors à l'état haut HRS est alors égal à n-pop.

Dans l'exemple de la figure 5, la deuxième résistance équivalente $R_{BLb}$ vérifie alors l'équation suivante :

[3]

$$\frac{1}{R_{BLb}} = \frac{pop}{LRS} + \frac{n - pop}{HRS} = \frac{pH + L(n - p)}{HL} = \frac{p(H - L) + nL}{HL}$$

où $R_{BLb}$ représente la deuxième résistance équivalente,

pop, ou encore la notation abrégée p, est égal au résultat de la fonction *popcount* de l'équation (1) précédente,

n représentant le nombre de lignes d'entrée $IN_i$,

HRS, ou encore la notation abrégée H, représente la résistance du memristor 28, 30 à l'état haut HRS, et
LRS, ou encore la notation abrégée L, représente la résistance du memristor 28, 30 à l'état bas LRS.

D'après les équations précédentes (2) et (3), la tension de la ligne de source SL vérifie alors l'équation suivante :

[4]

$$V(SL) - V(BLb) = \frac{R_{BLb}}{R_{BL} + R_{BLb}} * \Delta BL$$

$$= \frac{HL}{p(H-L) + nL} * \frac{1}{\frac{HL}{p(L-H)+nH} + \frac{HL}{p(H-L)+nL}} * \Delta BL$$

$$= \frac{1}{\frac{p(H-L)+nL}{p(L-H)+nH} + 1}$$

où V(SL) représente la tension de la ligne de source SL,
V(BLb) représente la tension de la ligne de bit complémentaire BLb, et
ΔBL représente le différentiel de tension entre la tension de la ligne de bit BL et la tension de la ligne de bit complémentaire BLb selon l'équation suivante :

[5]

$$\Delta BL = |V(BL) - V(BLb)|$$

Après simplification, la tension de la ligne de source SL vérifie alors l'équation suivante :

[6]

$$V(SL) = \frac{n * HRS + pop * (LRS - HRS)}{n(L + H)} * \Delta BL + V(BLb)$$

où V(SL) représente la tension de la ligne de source SL,
V(BLb) représente la tension de la ligne de bit complémentaire BLb,
ΔBL représente le différentiel de tension entre la tension de la ligne de bit BL et la tension de la ligne de bit complémentaire BLb selon l'équation (5),
pop est égal au résultat de la fonction *popcount* de l'équation (1) précédente,
n représentant le nombre de lignes d'entrée $IN_i$,
HRS, ou encore la notation abrégée H, représente la résistance du memristor 28, 30 à l'état haut HRS, et
LRS, ou encore la notation abrégée L, représente la résistance du memristor 28, 30 à l'état bas LRS.

L'homme du métier observera que l'équation (6) précédente dépend de la valeur pop, c'est-à-dire du résultat de la fonction *popcount* de l'équation (1) précédente. Plus la valeur pop sera grande, plus le terme |pop * (LRS - HRS)| sera grand, et comme le terme pop * (LRS - HRS) est négatif car HRS>LRS, plus le terme n * HRS + pop * (LRS - HRS) sera faible. Par conséquent, plus la valeur pop sera grande, plus la tension de la ligne de source SL sera faible, et proche de la tension de la ligne de bit complémentaire BLb.

Du fait de la variabilité des memristors en fonctionnement, telle que décrite précédemment en regard de la figure 3, une distribution 40 des tensions de la ligne de source SL selon l'équation (6) précédente comporte une pluralité de lobes 42, chaque lobe 42 représentant une densité de probabilité de la tension de la ligne de source SL pour une valeur pop donnée. Le nombre de lobes 42 contenus dans la distribution 40 est alors égal au nombre de valeurs possibles de la valeur pop, c'est-à-dire à n+1, avec n représentant le nombre de lignes d'entrée $IN_i$.

Le nombre de valeurs de seuil nécessaires pour déterminer la valeur de la tension de la ligne de source SL parmi ces n+1 lobes 42 est alors égal à n, ces valeurs d'un seuil th étant notés respectivement th=0 à th=n-1 dans l'exemple de la figure 5, avec n=5.

Le module de lecture 24 va être à présent décrit plus en détail, en regard des figures 5 à 9.

Le module de lecture 24 comporte une unité logique 50 pour chaque colonne 18, chaque unité logique 50

comprenant au moins une borne d'entrée 52 connectée à une ligne de source SL respective pour recevoir une valeur d'entrée dite valeur de colonne, et une borne de sortie 54. L'unité logique 50 est propre à effectuer une opération logique présentant un basculement entre une valeur basse et une valeur haute, en fonction d'une comparaison de la valeur de colonne par rapport à une valeur de seuil de basculement $INV_{th}$, lors de l'opération de calcul, le résultat, noté a, de l'opération logique étant délivré en la borne de sortie 54.

Selon l'invention, le module de lecture 24 comporte en outre une unité de modification 60 propre à modifier, pour au moins une unité logique 50 et en fonction de l'opération de calcul souhaitée, une différence entre la valeur de colonne et la valeur de seuil de basculement $INV_{th}$. Autrement dit, l'unité de modification est propre à modifier, pour au moins une unité logique 50 et en fonction de l'opération de calcul souhaitée, la valeur de seuil de basculement $INV_{th}$ par rapport à la valeur de colonne.

L'opération logique effectuée par l'unité logique 50 est de préférence une inversion, l'unité logique 50 étant typiquement un simple inverseur. L'unité logique 50 est alors propre à recevoir un signal incident sur sa borne d'entrée 52 et à effectuer un calcul d'inversion logique pour émettre sur sa borne de sortie 54 un signal de sortie qui est l'inverse du signal incident.

L'unité logique 50 peut comporter éventuellement d'autres « entrées » que la borne d'entrée 52 connectée à la ligne de source SL, mais ces éventuelles autres entrées doivent avoir une valeur neutre lors de l'opération de calcul, ces éventuelles autres entrées étant alors neutralisées. Dès lors, la valeur en sortie de l'unité logique 50 dépend uniquement de la valeur présente sur la ligne de source SL lors de l'opération de calcul, c'est-à-dire de la valeur reçue en la borne d'entrée 52. En dehors des opérations de calcul, les éventuelles autres entrées de l'unité logique 50 peuvent prendre des valeurs non-neutres.

A titre d'exemple du paragraphe précédent, l'unité logique 50 est une porte XOR avec une entrée fixée à 0. XOR est l'appellation anglaise de l'opération logique « OU exclusif ». Selon un autre exemple, l'unité logique 50 est une porte NAND avec une entrée fixée à 1. NAND est l'appellation anglaise de l'opérande « non ET ». Selon encore un autre exemple, l'unité logique 50 est une porte NOR avec une entrée fixée à 0. NOR est l'appellation anglaise de l'opérande « non OU ».

L'homme du métier comprendra alors que l'unité logique 50 ne réalise pas forcément dans sa globalité une opération d'inversion, mais peut comporter deux inverseurs en série pour former une porte logique non inverseuse. Ceci étant, l'unité logique 50 comprend l'équivalent d'au moins un inverseur et que la valeur de seuil de basculement à laquelle est comparée la tension de la ligne de source SL correspond à la valeur de seuil de basculement $INV_{th}$ de l'inverseur ou de l'inverseur équivalent à une porte logique plus complexe dont les autres entrées sont neutralisées.

L'homme du métier observera alors que si le module de lecture 24 comporte seulement l'unité de modification 60 en forme de simple inverseur, alors le module de lecture 24 peut comparer la tension de la ligne de source SL avec une seule valeur de seuil de basculement $INV_{th}$, comme représenté à titre d'exemple de l'état de la technique en partie inférieure de la figure 5. Dans cet exemple, l'unique valeur de seuil de basculement $INV_{th}$, également appelé seuil d'inversion, ou encore seuil de commutation, est choisie égale à 0,6 V soit le milieu entre la tension de la ligne de bit complémentaire BLb choisie égale à 0,3 V et la tension de la ligne de bit BL choisie égale à 0,9 V. Dans cet exemple, si la valeur pop, c'est-à-dire le résultat de la fonction *popcount,* est supérieure à un seuil milieu, c'est-à-dire égale à 3, 4 ou 5, alors la tension de la ligne de source SL est inférieure à 0,6V, et l'unité logique 50 donnera la valeur 1 en sa borne de sortie 54, la tension $U_{50}$ en la borne de sortie 54 représentée en trait pointillé étant alors à VDD. Si la valeur pop est inférieure au seuil milieu, c'est-à-dire égale à 0, 1 ou 2, alors la tension de la ligne de source SL est supérieure à 0,6V, et l'unité logique 50 donnera la valeur 0 en sa borne de sortie 54, la tension $U_{50}$ en la borne de sortie 54 étant alors à 0.

Ainsi, avec un simple inverseur, il est possible d'effectuer la comparaison de la valeur pop avec un seuil, tel que le seuil du milieu. Cependant, cela est insuffisant pour effectuer une opération neuronale, où la valeur du seuil n'est pas fixée à la valeur moyenne. C'est la raison pour laquelle l'état de la technique utilise généralement un comparateur complet en bas de colonne pour comparer la valeur pop à n'importe quel seuil défini lors de l'entrainement. Or, l'utilisation d'un comparateur en bas de colonne nécessite une surface importante (bien plus importante qu'un simple inverseur), une consommation non négligeable et un faible parallélisme due au multiplexage en bas de colonne.

Selon l'invention, l'unité de modification 60 permet alors de modifier, pour au moins une unité logique 50 et en fonction de l'opération de calcul souhaitée, la différence entre la valeur de colonne et la valeur de seuil de basculement $INV_{th}$, c'est-à-dire de modifier la valeur de seuil de basculement $INV_{th}$ par rapport à la valeur de colonne.

L'unité de modification 60 permet alors notamment de comparer la valeur pop, c'est-à-dire le résultat de la fonction *popcount,* à n'importe quelle valeur de seuil, en ayant en bas de colonne seulement l'unité logique 50, typiquement en forme simple inverseur, comme illustré sur les figures 7 à 9.

L'unité de modification 60 est, par exemple, propre à modifier la différence entre la valeur de colonne et la valeur de basculement $INV_{th}$ pour une unité logique 50 respective, en commandant une modification des tensions complémentaires appliquées sur la paire de lignes de bit complémentaires BL, BLb pour la colonne 18 associée à ladite unité logique 50.

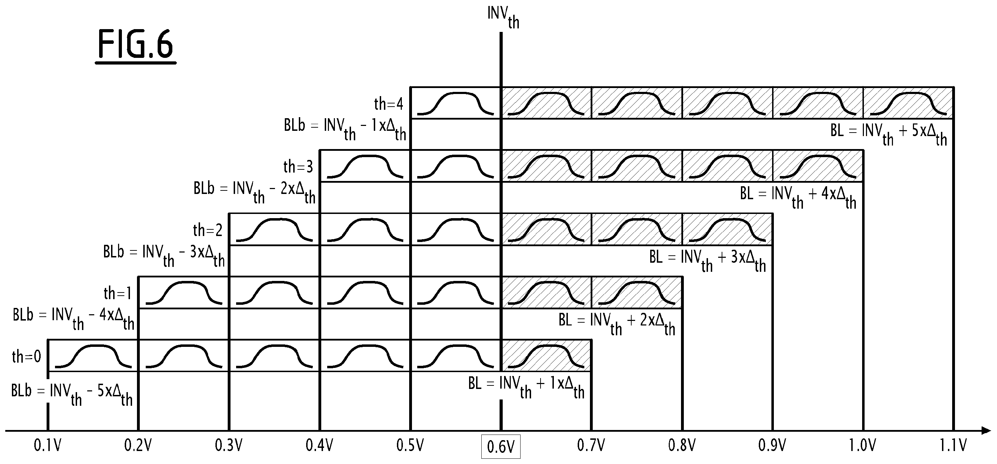

Dans l'exemple de la figure 6, pour obtenir le premier seuil th=0 de la figure 5, la tension de la ligne de bit complémentaire BLb est commandée à la valeur $INV_{th}$-5*$\Delta$th, soit par exemple 0,1 V, et la tension de la ligne de bit BL est commandée à la valeur $INV_{tn}$+$\Delta$th, soit par exemple 0,7 V, pendant que la valeur de seuil de basculement $INV_{th}$, est inchangée, restant égale à 0,6 V dans cet exemple. Pour obtenir le deuxième seuil th=1 de la figure 5, la tension de la ligne de bit complémentaire BLb est commandée à la valeur $INV_{th}$-4*$\Delta$th, soit par exemple 0,2 V, et la tension de la ligne de bit BL est commandée à la valeur $INV_{th}$+2*$\Delta$th, soit par exemple 0,8 V, pendant que la valeur de seuil de basculement $INV_{th}$, est inchangée, par exemple à 0,6 V. Pour obtenir le troisième seuil th=2 de la figure 5, la tension de la ligne de bit complémentaire BLb est commandée à la valeur $INV_{th}$-3*$\Delta$th, soit par exemple 0,3 V, et la tension de la ligne de bit BL est commandée à la valeur $INV_{th}$+3*$\Delta$th, soit par exemple 0,9 V, pendant que la valeur de seuil de basculement $INV_{th}$, est inchangée, par exemple à 0,6 V. Pour obtenir le quatrième seuil th=3 de la figure 5, la tension de la ligne de bit complémentaire BLb est commandée à la valeur $INV_{th}$-2*$\Delta$th, soit par exemple 0,4 V, et la tension de la ligne de bit BL est commandée à la valeur $INV_{th}$+4*$\Delta$th, soit par exemple 1 V, pendant que la valeur de seuil de basculement $INV_{th}$, est inchangée, par exemple à 0,6 V. Enfin, pour obtenir le cinquième seuil th=4 de la figure 5, la tension de la ligne de bit complémentaire BLb est commandée à la valeur $INV_{th}$-$\Delta$th, soit par exemple 0,5 V, et la tension de la ligne de bit BL est commandée à la valeur $INV_{th}$+5*$\Delta$th, soit par exemple 1,1 V, pendant que la valeur de seuil de basculement $INV_{th}$, est inchangée, par exemple à 0,6 V.

L'homme du métier observera que dans cet exemple de la figure 6, la modification des tensions complémentaires de la paire de lignes de bit complémentaires BL, BLb est effectuée avec une variation selon un pas de variation $\Delta$th d'un seuil au suivant.

Le pas de variation $\Delta$th vérifie par exemple l'équation suivante :

[7]

$$\Delta\text{th} = \left(\frac{(p+1)L + H(n-p-1)}{n(L+H)} - \frac{pL + H(n-p)}{n(L+H)}\right) * \Delta BL = \frac{H-L}{n(L+H)} * \Delta BL$$

où $\Delta$BL représente le différentiel de tension entre la tension de la ligne de bit BL et la tension de la ligne de bit complémentaire BLb selon l'équation (5),

pop, ou encore la notation abrégée p, est égal au résultat de la fonction *popcount* de l'équation (1) précédente,

n représentant le nombre de lignes d'entrée $IN_i$,

HRS, ou encore la notation abrégée H, représente la résistance du memristor 28, 30 à l'état haut HRS, et

LRS, ou encore la notation abrégée L, représente la résistance du memristor 28, 30 à l'état bas LRS.

En variante, non représentée, l'unité de modification 60 est propre à modifier la différence entre la valeur de colonne et la valeur de seuil de basculement $INV_{th}$ pour une unité logique 50 respective, en commandant une modification de la valeur de seuil de basculement $INV_{th}$ de ladite unité logique 5.

Selon cette variante, la valeur de seuil de basculement $INV_{th}$ est par exemple modifiée via un changement de la tension d'alimentation de ladite unité logique 50, ou via un changement de la tension de polarisation d'une grille arrière d'au moins un transistor de ladite unité logique 50, ou encore via à la fois le changement de la tension d'alimentation et le changement de la tension de polarisation.

En complément facultatif, l'unité de modification 60 est propre à modifier, de manière incrémentale selon un pas d'incrémentation prédéfini, ladite différence entre la valeur de colonne et la valeur de seuil de basculement $INV_{th}$, pour déterminer - parmi une pluralité de valeurs possibles prédéfinies - une valeur résultante correspondant à la tension de la ligne de source SL respective, c'est-à-dire correspondant à ladite valeur de colonne. Le pas d'incrémentation dépend de ladite pluralité de valeurs possibles. Selon ce complément facultatif, le pas d'incrémentation est par exemple égal au pas de variation $\Delta$th défini précédemment.

Lorsque l'opération de calcul effectuée est une opération de calcul neuronal, telle que l'opération MAC, le circuit électronique 10 selon l'invention avec l'ensemble de cellules mémoire 12 organisées selon la matrice 14 comportant n rangées 16 et m colonnes 18, permet alors d'implémenter un réseau de neurones 65 à n entrées et m sorties, tel qu'un réseau de neurones entièrement connecté (de l'anglais *fully connected*), comme représenté à la figure 7. Dans l'exemple de la figure 7, le circuit électronique 10 comprend alors n*m cellules mémoire 12, chacune comportant deux paires de memristors 28, 30 et deux paires de commutateurs 32, 34, soit n*m cellules de type 4T4R ; ainsi que n paires de lignes de mot complémentaires WL, WLb, soit 2*n lignes de mot WL, WLb ; m lignes de source SL ; et m paires de lignes de bit complémentaires BL, BLb, soit 2*m lignes de bit BL, BLb.

En raison de la forte variabilité des memristors 28, 30, le circuit électronique 10 est préférentiellement limité à 9 entrées activées simultanément, soit n égal à 9. Dans le cas où les réseaux de neurones utilisés nécessitent des neurones plus grands que 9 entrées (ce qui est très fréquent), il convient alors avantageusement de diviser le neurone global en portions de 9 entrées, et de sommer les résultats du MAC de chaque portion pour obtenir le popcount global, que l'on comparera au seuil propre au neurone. Cette division du neurone global en portion de 9 entrées est connue en soi, et présente même un aspect pratique, car les filtres de convolutions usuels ont une taille de 3 par 3, soit 9 entrées au total.

Par conséquent, la génération des tensions des paires de lignes de bit complémentaires BL, BLb est avantageusement mutualisée pour toutes les colonnes 18 de la matrice 14, diminuant ainsi la complexité de la génération des décalages des tensions des paires de lignes de bit complémentaires BL, BLb, décrits précédemment pour modifier successivement la valeur de seuil de basculement $INV_{th}$ par rapport à la valeur de colonne. Tous les seuils th=0 à th=n-1 sont alors préférentiellement testés successivement dans l'ordre croissant, ou alternativement dans l'ordre décroissant, résultant en sortie de chaque unité logique 50 en une suite de bits qui correspond à la valeur du MAC partiel à 9 entrées. Cette suite de bits est d'ailleurs interprétable par un codage de type thermométrique, proche du codage one-hot. Cette suite de bits contient une suite de 1 qui correspond aux seuils plus faibles que la valeur pop (résultat de la fonction *popcount*).

En complément facultatif, le module de lecture 24 comporte en outre une unité d'extinction 70 pour chaque colonne 18, chaque unité d'extinction 70 étant propre - après détermination de la valeur résultante pour la colonne 18 respective et dans l'attente de la détermination de toutes les valeurs résultantes pour un groupe respectif de colonnes 18 - à commander l'application de la même tension à la paire de lignes de bit complémentaires BL, BLb pour la circulation d'un courant sensiblement nul dans la ligne de source SL de la colonne 18 respective.

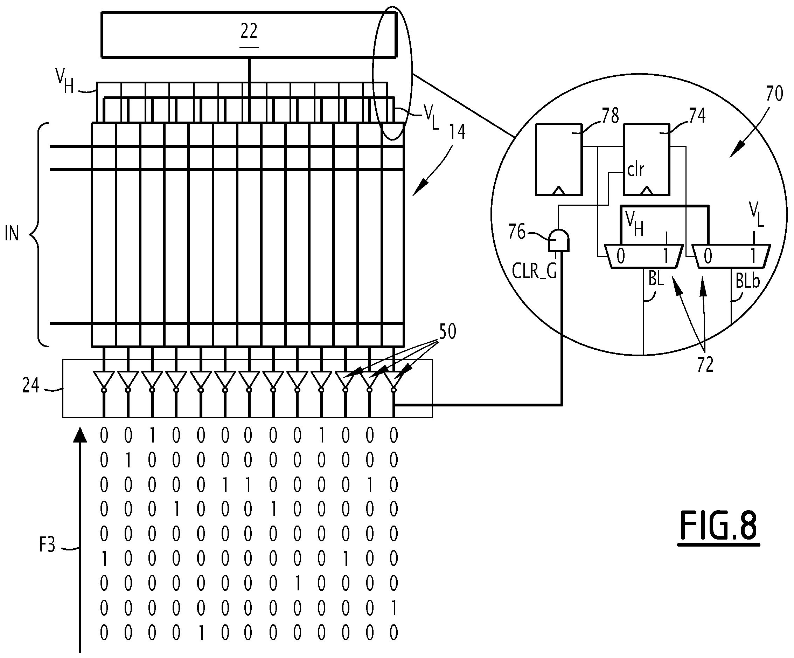

Chaque unité d'extinction 70 permet alors de limiter la consommation en courant en sortie de la ligne de source SL correspondante, en « éteignant » la colonne correspondante dès l'obtention de son premier « 1 » en sortie de l'unité logique 50. De plus, on obtient alors un codage one-hot complet, comme représenté à la figure 8, sans la suite inutile de 1.

Le deuxième contrôleur 20 propre à commander les paires de lignes de bit complémentaires BL, BLb contient généralement deux multiplexeurs à deux entrées 72, un pour chaque ligne de bit BL, BLb, chaque multiplexeur 72 étant utile pour les opérations d'écriture et lecture classiques. Ces multiplexeurs 72 sont contrôlés par des bits de contrôle stockés dans des registres. Chaque unité d'extinction 70 est alors par exemple obtenue en reliant la sortie de chaque unité logique 50 au signal clr de mise à zéro, i.e. de réinitialisation (de l'anglais *clear* ou *reset*), d'une bascule 74 de commande de sa ligne de bit complémentaire BLb respective, ceci via une porte logique ET 76, qui est également reliée à un signal d'effacement global CLR_G, comme représenté dans l'exemple de la figure 8. Dans l'exemple de la figure 8, l'autre bascule 78 est une bascule de commande de la ligne de bit BL respective.

Dans l'exemple de la figure 8, à la fin de chaque décalage des tensions des paires de lignes de bit complémentaires BL, BLb, si la sortie de l'unité logique 50 est un « 1 », cette sortie va effacer la bascule 74 de commande de la ligne de bit complémentaire BLb respective au cycle suivant, mettant ainsi les deux tensions des paires de lignes de bit complémentaires BL, BLb à la tension de la ligne de bit BL, c'est-à-dire à la tension haute $V_H$, et résultant ainsi en un courant nul au sein de la colonne 18 concernée, puis en un « 0 » en sortie de l'unité logique 50 correspondante. Dans cet exemple, il faut simplement commencer par le seuil le plus élevé, en allant en décrément vers le seuil le moins élevé. Sur la figure 8, le sens de l'évolution temporelle pour la succession de bits en sortie de chaque unité logique 50 est représentée par la flèche F3.

En complément facultatif, les sorties successives des unités logiques 50 sont stockées dans des registres propres à chaque colonne 18.

En complément facultatif encore, le module de lecture 24 comporte en outre une unité de mémorisation 80 pour chaque colonne 18, chaque unité de mémorisation 80 étant propre à stocker la valeur résultante déterminée pour la colonne 18 respective, dans l'attente de la détermination de toutes les valeurs résultantes pour un groupe respectif de plusieurs colonnes 18.

Chaque unité de mémorisation 80 comporte de préférence un registre de bits 82 pour stocker sous forme binaire ladite valeur résultante déterminée. Chaque unité de mémorisation 80 est avantageusement en forme du registre de bits 82.

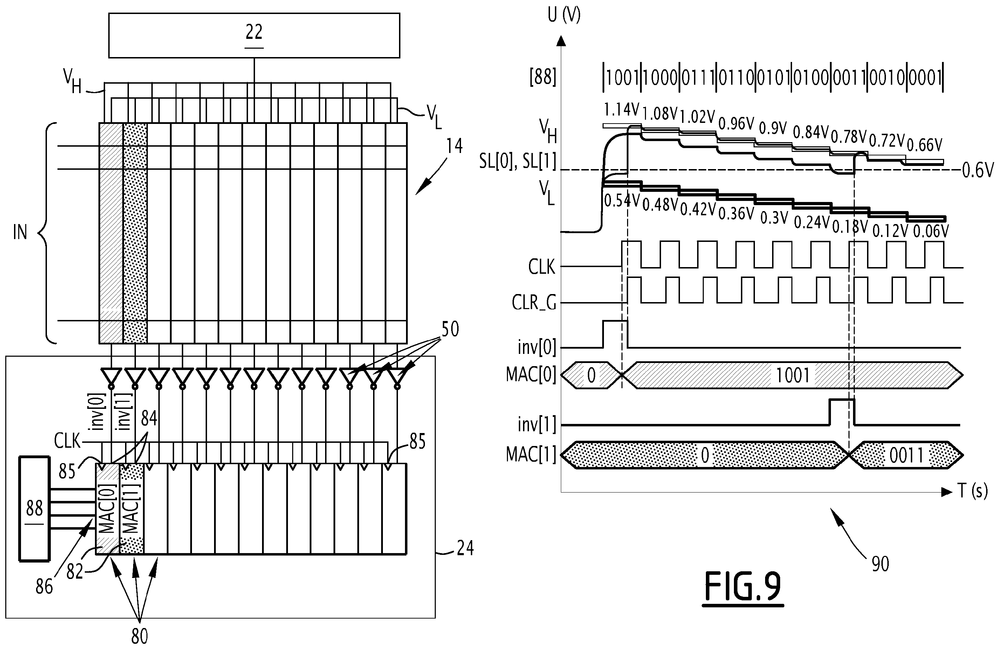

Selon ce complément facultatif, dans l'exemple de la figure 9, chaque sortie d'unité logique 50 est connectée à un registre de bits 82 respectif, chaque sortie pilotant le signal « enable » 84 du registre 82 associé. Ce registre 82 contient typiquement 4 bits, car il suffit de 4 bits pour coder une opération MAC dont la valeur varie entre 0 et 9. Les registres 82 ont en outre une entrée d'horloge 85 recevant un signal d'horloge CLK et une entrée 86 commune et parallèle à tous les registres 82. Cette entrée commune 86 est pilotée par un compteur (ou décompteur) 88. Le compteur (ou décompteur) 88 est avantageusement le même que celui utilisé dans le contrôle des paires de lignes de bit complémentaires BL, BLb.

La figure 9 illustre le fonctionnement global de telles unités de mémorisation 80, avec un chronogramme montrant deux cas : en gris foncé une colonne avec un MAC égal à 9, et en gris clair une colonne avec un MAC égal à 3.

Après avoir sélectionné les lignes d'entrée IN correspondant aux entrées des neurones, les tensions des paires de lignes de bit complémentaires BL, BLb correspondant au premier seuil souhaité (par exemple ici le seuil le plus élevé) sont d'abord appliquées aux paires de lignes de bit complémentaires BL, BLb. La sortie, notée inv[0], de l'unité logique 50 de la colonne en hachuré se met à 1, car son opération MAC, notée MAC[0], est maximale et est égale à 9. Par conséquent, quand l'horloge CLK des registres 82 passe à 1, le registre 82 de la colonne en hachuré capture le code binaire du compteur 88, qui correspond à la valeur 9. Par la suite, au front du signal d'effacement global CLR_G, la bascule 74 de

EP 4 354 351 B1

commande de la ligne de bit complémentaire BLb de la colonne en hachuré est effacée, égalisant - par exemple au potentiel haut $V_H$ - les tensions des paires de lignes de bit complémentaires BL, BLb de cette colonne 18, pour « l'éteindre » dans la suite des calculs avec les seuils restants, fixant à 0 la sortie de son unité logique 50, notée inv[0]. Quant à la colonne remplie de points, la sortie, notée inv[1], de son unité logique 50 reste à 0 jusqu'au cycle du seuil « 3 », où elle bascule à 1 car son opération MAC, notée MAC[1], est égale à 3, et suis ensuite la même séquence que la colonne en hachuré.

Des simulations effectuées de ce neurone à 9 entrées montrent d'excellents résultats. En effet, lorsque la variabilité des transistors formant les commutateurs 32, 34 n'est pas simulée, le taux d'erreur en sortie de l'unité logique 50 est nul pour tous les cas de figure, c'est-à-dire quelle que soit la valeur pop résultant de la fonction *popcount* et quelle que soit la valeur du seuil. Lorsque ladite variabilité des transistors est simulée, le taux d'erreur en sortie de l'unité logique 50 est similaire à celui d'une approche classique, tout en observant que la consommation électrique avec le circuit électronique 10 selon l'invention est alors nettement plus faible, typiquement plus de 80 fois plus faible, que celle du circuit de l'état de la technique, pour une latence meilleure ou équivalente.

L'homme du métier observera alors que le circuit électronique 10 selon l'invention permet alors d'effectuer efficacement l'opération de calcul neuronal, telle que l'opération MAC selon l'équation (1) précédente, et en requérant une faible surface pour les composants mettant en œuvre ladite opération, tout en ayant également une faible consommation, et en offrant une possibilité accrue de parallélisme, comme représenté sur la figure 7 notamment.

Dans l'exemple de la figure 10, chaque cellule mémoire 12 comporte une seule paire de memristors 28, 30, c'est-à-dire un seul premier memristor 28 et un seul deuxième memristor 30, et une seule paire de commutateurs 32, 34, c'est-à-dire un seul premier commutateur 32 et un seul deuxième commutateur 34.

Selon l'exemple de la figure 10, chaque cellule mémoire 12 est également propre à mémoriser au moins une valeur binaire, telle qu'un poids binaire, en particulier un poids synaptique binaire respectif du réseau de neurones lorsque l'opération de calcul effectuée est une opération de calcul neuronal.

Le codage de chaque cellule mémoire 12 est par exemple celui décrit dans l'article *« Efficient and Robust Nonvolatile Computing-In-Memory Based on Voltage Division in 2T2R RRAM With Input-Dependent Sensing Control »* de L. Wang et al. (2021). Chaque colonne 18 présente aussi une paire de lignes de bit complémentaires BL, BLb et une ligne de source SL. Chaque rangée 16 comporte alors une seule ligne de mot WL. Les premier et deuxième memristors 28, 30 sont utilisés pour coder chaque poids en différentiel (HRS-LRS ou LRS-HRS), de manière analogue à ce qui a été décrit précédemment. Une tension est ensuite appliquée entre les lignes de bit complémentaires BL, BLb de la colonne 18, créant ainsi un pont résistif entre les memristors des côtés gauche et droit de la colonne 18. La tension résultante correspond au résultat de l'opération MAC, effectuée cette fois-ci avec une opération ET (de l'anglais *AND*), plutôt que l'opération XNOR décrite précédemment.

Pour éviter d'avoir parfois un nombre pair de cellules mémoire 12 activées, une ligne de mot de parité WL_p est ajoutée, et cette ligne de mot de parité WL_p est configurée pour activer les cellules mémoire 12 de type 2T2R (codées en HRS, LRS), qui s'activeraient si le nombre d'entrées IN est pair. De ce fait, les distributions de tensions seront toujours de part et d'autre du seuil de l'unité logique. Cette ligne de mot de parité WL_p est avantageuse surtout lorsque l'opération de calcul est l'opération Majorité logique.

Une fois ce problème de symétrie résolu, le nombre de décalages de seuil via les variations des tensions des paires de lignes de bit complémentaires BL, BLb est adapté au nombre de lignes de mot WL activées. La valeur maximale du compteur (ou décompteur) 88 est alors égale au nombre de lignes de mot WL activées plus un. Les tensions des paires de lignes de bit complémentaires BL, BLb qui sont symétriques par rapport au seuil de l'inverseur correspondent au seuil du milieu, un décalage vers le haut correspondra à un seuil plus bas, et un décalage vers le bas correspondra à un seuil plus haut. Dans le cas où le nombre de lignes de mot WL est pair, l'homme du métier comprendra qu'il ne faut pas considérer le seuil le plus « bas », qui correspond simplement à la cellule mémoire 12 associée à la ligne de mot de parité WL_p.

L'avantage de cet exemple de la figure 10 est, qu'en activant seulement les lignes de mot WL nécessaires, on diminue fortement le courant dans les colonnes 18. La cellule mémoire 12 utilisée est en outre une cellule 2T2R, plutôt qu'une cellule mémoire 4T4R dans les exemples des figures 2, 4 et 7. De plus, cet exemple de la figure 10 permet de diminuer aussi le nombre de décalages de seuil via les variations des tensions des paires de lignes de bit complémentaires BL, BLb, ce nombre s'adaptant en fonction du nombre de lignes de mot WL activées.

En variante, aucune ligne de mot de parité n'est ajoutée, et le circuit électronique 10 comprend alors en outre une unité de contrôle configurée pour adapter de manière analogique les tensions des paires de lignes de bit complémentaires BL, BLb dans le cas où le nombre de lignes de mot WL activées est impair.

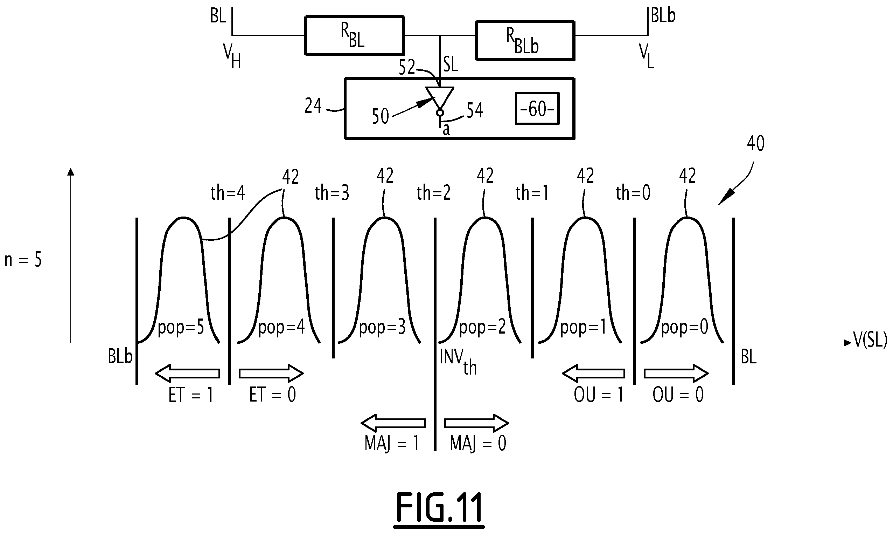

Dans l'exemple de la figure 11, l'opération de calcul effectuée par le circuit électronique 10 est une opération ET sur des opérandes binaires, ou une opération OU sur des opérandes binaires, ou encore une opération Majorité parmi des opérandes binaires.

Dans l'exemple de la figure 11, la distribution 40 des tensions de la ligne de source SL est similaire à celle de la figure 5, décrite précédemment, et comporte la pluralité de lobes 42, chaque lobe 42 représentant une densité de probabilité de la tension de la ligne de source SL pour une valeur pop donnée. Le nombre de lobes 42 contenus dans la distribution 40 est alors égal au nombre de valeurs possibles de la tension de la ligne de source S(VL), c'est-à-dire à n+1, avec n représentant le nombre de lignes d'entrée $IN_i$.

Le nombre de valeurs de seuil nécessaires pour déterminer la valeur de la tension de la ligne de source SL parmi ces n+1 lobes 42 est alors égal à n, ces valeurs d'un seuil th étant notés respectivement th=0 à th=n-1 dans l'exemple de la figure 11, avec n=5.

Toutefois, lorsque l'opération de calcul effectuée est l'opération ET sur des opérandes binaires, ou l'opération OU sur des opérandes binaires, ou encore l'opération Majorité parmi des opérandes binaires, l'homme du métier observera qu'un seul seuil est nécessaire à chaque fois.

En effet, l'opération ET sur la pluralité d'opérandes binaires est égale à 1 si et seulement si tous les opérandes binaires sont égaux à 1, et égale à 0 dans tous les autres cas. Le seuil est alors positionné de manière à pouvoir détecter ce lobe de densité de probabilité de tension correspondant au cas où tous les opérandes sont égaux à 1, et déterminer alors si tous les opérandes sont égaux à 1 ou non, puis en déduire le résultat de l'opération ET.

Inversement, l'opération OU sur la pluralité d'opérandes binaires est égale à 0 si et seulement si tous les opérandes binaires sont égaux à 0, et égale à 1 dans tous les autres cas. Le seuil est alors positionné de manière à pouvoir détecter ce lobe de densité de probabilité de tension correspondant au cas où tous les opérandes sont égaux à 0, et déterminer alors si tous les opérandes sont égaux à 0 ou non, puis en déduire le résultat de l'opération OU.

Dans l'exemple de logique de codage précitée où la valeur binaire est encodée égale à 1, avec pour la première paire de memristors 28, 30 (ou la seule paire dans l'exemple de la figure 10), le memristor de gauche, i.e. le premier memristor 28, est codé en forte résistance (état haut HRS), et le memristor de droite, i.e. le deuxième memristor 30, est codé en faible résistance (état bas LRS), l'unique seuil utilisé est alors le seuil le plus bas pour implémenter l'opération ET (de l'anglais *AND*), et respectivement le seuil le plus haut pour implémenter l'opération OU (de l'anglais *OR*), et respectivement encore le seuil du milieu pour l'opération Majorité, comme représenté sur la figure 11.

L'opération de calcul permet alors d'effectuer un ET logique, ou un OU logique, ou encore une Majorité logique pour chaque colonne 18 séparément pour l'ensemble des rangées 16 de la matrice 14, et ce seulement pour les rangées dont les lignes de mot WL sont activées. Le circuit électronique 10 selon cet exemple de l'invention permet alors d'activer plusieurs rangées 16 en parallèle pour faire le calcul booléen - à savoir ET logique, ou OU logique, ou encore une Majorité logique - bit à bit sur plusieurs entrées en parallèle.

De manière générale, la valeur du seuil de basculement $INV_{th}$ dépend de l'opération de calcul associée.

Dans l'exemple de la figure 11, lorsque l'opération de calcul associée est l'opération ET ou l'opération OU, la valeur du seuil de basculement $INV_{th}$ est typiquement à un pas de tension d'une tension de ligne bit BL, BLb correspondante, la tension de ligne bit BL, BLb correspondante étant l'une des tensions de lignes de bit complémentaires BL, BLb pour l'opération ET et l'autre desdites tensions pour l'opération OU.

Le pas de tension vérifie typiquement l'équation suivante :

[8]

$$P = \frac{\Delta BL}{OPD + 1}$$

où P représente le pas de tension ;
$\Delta BL$ représente le différentiel de tension entre la tension de la ligne de bit BL et la tension de la ligne de bit complémentaire BLb, et
OPD représente le nombre d'opérandes auxquelles l'opération de calcul est appliquée.

Dans l'exemple de la figure 11, lorsque l'opération de calcul associée est l'opération Majorité, la valeur du seuil de basculement $INV_{th}$ est typiquement la valeur médiane des tensions de lignes de bit complémentaires BL, BLb. Tous les cas où le résultat de l'opération Majorité est égal à 1 correspondent alors à des lobes 42 de densité de probabilité de tension disposés du même côté de ce seuil médian ; et tous les cas où le résultat de l'opération Majorité est égal à 0 correspondent alors à des lobes 42 de densité de probabilité de tension disposés de l'autre côté dudit seuil médian.

En complément facultatif encore, le module de lecture 24 comporte en outre une unité de combinaison 90 pour au moins une colonne 18, chaque unité de combinaison 90 étant propre à combiner les résultats d'opérations logiques effectuées successivement par une unité logique 50 respective, pour mettre en œuvre une opération logique combinée. L'opération logique combinée est typiquement choisie parmi le groupe consistant en : une opération de ou-exclusif et une opération de non-ou-exclusif.

Chaque unité de combinaison 90 comporte de préférence une bascule 92 connectée en sortie de l'unité logique 50 respective. Chaque unité de combinaison 90 est avantageusement en forme de la bascule 92.

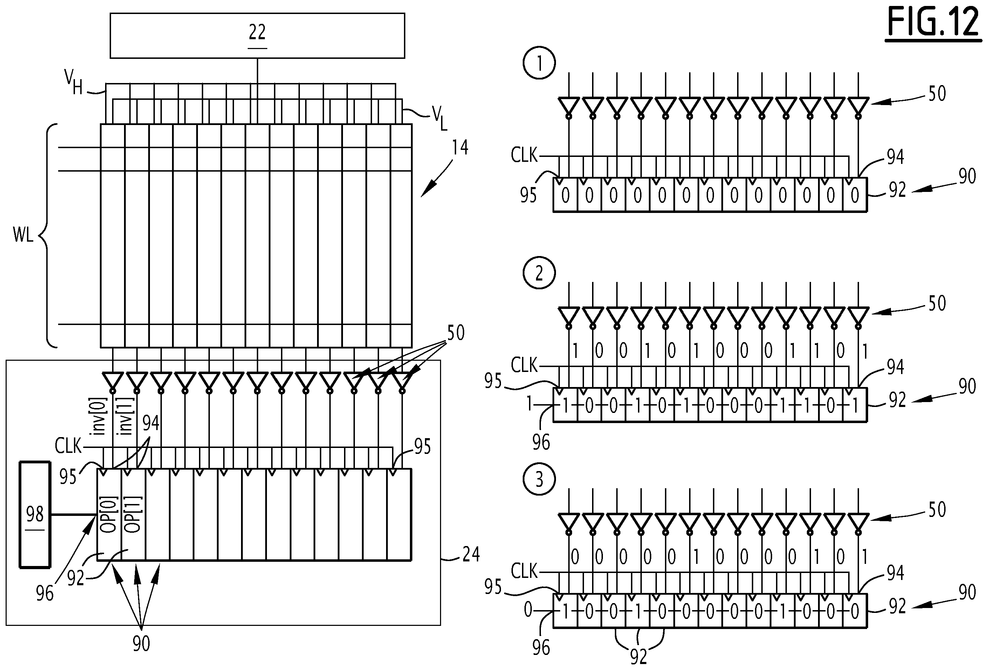

Selon ce complément facultatif, dans l'exemple de la figure 12, chaque sortie d'unité logique 50, notée inv[0] pour la première colonne 18, puis inv[1] pour la deuxième colonne 18, et ainsi de suite, est connectée à une bascule 92 respective, chaque sortie inv[i] pilotant le signal « enable » 94 de la bascule 92 associée, avec i indice entier compris entre 0 et le nombre de colonnes 18 moins un. Les bascules 92 ont en outre une entrée d'horloge 95 recevant un signal d'horloge CLK et une entrée 96 commune et parallèle à toutes les bascules 82. Cette entrée commune 96 est pilotée par une unité de commande 98. L'unité de commande 98 est avantageusement commune avec celle utilisée dans le contrôle des paires de lignes de bit complémentaires BL, BLb. *(A vérifier par l'inventrice)*

La figure 12 illustre le fonctionnement global de telles unités de combinaison 90, avec par exemple une séquence en trois étapes.

Lors d'une première étape initiale, repérée par un 1 encerclé, le contenu de toutes les bascules 92 est réinitialisé à 0 via l'application d'un signal d'effacement (de l'anglais *clear*), comme connu en soi.

Lors d'une deuxième étape, repérée par un 2 encerclé, les deux opérandes de chaque colonne 18 auxquels l'opération logique combinée, telle qu'une opération de ou-exclusif, ou XOR, est à appliquer sont tout d'abord sélectionnés via les lignes de mot WL correspondantes.

Dans l'exemple de la figure 12, lors de cette deuxième étape, une opération OU est alors effectuée avec les deux opérandes de chaque colonne 18, et via chaque unité logique 50 respective, de la manière décrite précédemment en regard de la figure 11. Le résultat de chaque opération OU est alors appliqué sur l'entrée Enable de la bascule 92 correspondante et lors d'un prochain front du signal d'horloge CLK, en appliquant la valeur 1 sur l'entrée commune 96 des bascules 92. Il en résulte que les bascules 92 dont l'entrée Enable est à « 1 » prennent la valeur « 1 » et les autres bascules 92 dont l'entrée Enable est à « 0 » gardent la valeur « 0 » correspondant à l'étape de réinitialisation précédente.

Lors d'une troisième étape, repérée par un 3 encerclé, une nouvelle opération logique est effectuée avec les deux opérandes de chaque colonne 18, et via chaque unité logique 50 respective.

Dans l'exemple de la figure 12, lors de cette troisième étape, une opération ET est alors effectuée avec les deux opérandes de chaque colonne 18, et via chaque unité logique 50 respective, de la manière décrite précédemment en regard de la figure 11. Une opération ET entre le résultat de la précédente opération OU et le résultat inverse de chaque opération ET (c'est-à-dire le résultat complémenté à 1 de chaque opération ET) est alors obtenu dans la bascule 92 correspondante au prochain front du signal d'horloge CLK, en appliquant la valeur 0 sur l'entrée commune 96 des bascules 92. En effet, lors du prochain front du signal d'horloge CLK, la valeur 0 sur l'entrée commune 96 sera forcée dans les bascules 92 pour lesquelles le signal « enable » 94 est à 1, c'est-à-dire celles pour lesquelles le résultat de l'opération ET effectuée lors de la troisième étape est égal à 1. Autrement dit, si l'opération de NON-ET appliquée avec les deux opérandes de chaque colonne 18 est égal à 1, alors le signal « enable » 94 est à 0, et le résultat de l'opération OU de la deuxième étape est alors conservé dans la bascule 92 correspondante.

En d'autres termes encore, dans l'exemple de la figure 12, l'unité de combinaison 90 permet alors d'effectuer une opération de ou-exclusif, notée XOR, avec les deux opérandes de chaque colonne 18, compte tenu de l'équation suivante :

[9]

$$XOR(a, b) = (a\ OR\ b)\ AND\ \overline{(a\ AND\ b)} = (a+b) \cdot \overline{(a \cdot b)}$$

où XOR désigne l'opération de ou-exclusif ;

a et b représentent les deux opérandes ;

OR, ou encore « + », désigne l'opération logique OU ;

AND, ou encore « . », désigne l'opération logique ET ; et

- représente l'opérateur NON.

Dans l'exemple de la figure 12, le résultat de l'opération logique combinée, obtenu dans chaque bascule 92 à la fin de la séquence est alors noté OP[i], avec i indice entier compris entre 0 et le nombre de colonnes 18 moins un, c'est-à-dire OP[0] pour la première colonne 18, puis OP[1] pour la deuxième colonne 18, et ainsi de suite.

L'homme du métier comprendra alors que les bascules 92 permettent plus généralement de mettre en œuvre tout type de combinaison d'opérations logiques ET ou OU pour réaliser des opérations logiques combinées, les opérations logiques ET ou OU étant effectuées via les unités logiques 50, tel que décrit précédemment en regard de la figure 11.

L'homme du métier observera en outre que, si seulement les deux premières étapes repérées par le 1 et le 2 encerclés sont mises en œuvre, les bascules 92 forment alors un moyen de mémorisation du résultat des opérations logiques effectuées par les unités logiques 50.

Selon un aspect complémentaire facultatif, le circuit électronique 10 selon l'invention comprend en outre des commutateurs additionnels, non représentés, configurés pour connecter entre elles les lignes de source SL d'un groupe de plusieurs colonnes 18, et effectuer alors les opérations logiques par groupe de colonnes 18, plutôt que par groupe de rangées 16.

Selon cet aspect complémentaire, l'unité logique 50 utilisée pour effectuer l'opération logique pour ledit groupe de colonnes 18 est préférentiellement celle connectée à la ligne de source SL qui est apte à être connectée à toutes les autres lignes de source SL des colonnes 18 du groupe.

Selon cet aspect complémentaire, toutes les lignes de source SL sont optionnellement connectées entre elles via les commutateurs additionnels, qui sont alors avantageusement configurés pour être tous fermés lors de chaque opération de calcul. Le cas échéant, le deuxième contrôleur 22 inhibe la ou les colonnes 18 n'appartenant pas au groupe de colonnes 18 pour lesquelles l'opération logique est à effectuer, en appliquant un potentiel de haute impédance aux paires de lignes de bit complémentaires BL, BLb de ladite ou desdites colonnes 18 n'appartenant pas au groupe de colonnes 18. Cela simplifie alors la commande des commutateurs additionnels.

On notera qu'il est possible en pratique de combiner, en même temps, les deux possibilités de « combinaison d'opérandes » en colonnes 18 ou en rangées 16 en sélectionnant des opérandes sur plusieurs rangées 16 et en reliant les colonnes 18 comme décrit ci-dessus via une connexion entre leurs lignes de source SL.

Dans les exemples des figures 2, 4, 7 et 10, chaque memristor 28, 30 d'une cellule mémoire 12 respective est relié à la même ligne de source SL et à un commutateur 32, 34 respectif.

L'homme du métier comprendra qu'en variante, non représentée, chaque cellule mémoire 12 d'une colonne 18 respective comprend au moins une paire de sous-cellules, non représentées, chaque sous-cellule comportant un memristor 28, 30 et un commutateur 32, 34, chaque memristor 28, 30 d'une sous-cellule respective étant connecté à une ligne de source et à un commutateur 32, 34 respectifs. De manière analogue, les memristors 28, 30 de chaque paire de sous-cellules mémorisent alors respectivement une valeur binaire en présentant respectivement des première et deuxième valeurs de résistances différentes. Similairement, les commutateurs 32, 34 sont reliés, pour leur activation, à une ligne de mot WL respective et reliés respectivement à une paire de lignes de bit complémentaires BL, BLb, les deux commutateurs 32, 34 d'une paire respective de sous-cellules étant reliés à une même ligne de mot WL.

Selon cette variante, les deux lignes de source associées à une paire respective de sous-cellules sont alors connectées entre elles lors de chaque opération de calcul via un commutateur auxiliaire, non représenté, pour former alors la même ligne de source SL, également appelée ligne de source commune aux cellules mémoire 12 d'une même colonne 18, à laquelle chaque memristor 28, 30 d'une cellule mémoire 12 respective est relié lors de chaque opération de calcul.

On conçoit ainsi que le circuit électronique 10 selon l'invention permet de déterminer plus efficacement une valeur résultante correspondant à la tension de la ligne de source SL respective, de par son module de lecture 24 comportant une unité logique 50 pour chaque colonne 18 et l'unité de modification 60 propre à modifier, pour au moins une unité logique 50 et en fonction de l'opération de calcul, la différence entre la valeur de colonne et la valeur de seuil de basculement $INV_{th}$ de l'unité logique 50 correspondante.

**Revendications**

1. Circuit électronique (10) propre à mettre en œuvre des opérations de calcul fournissant chacune une sortie binaire, le circuit comprenant :

   - des lignes de mot (WL) ;
   - des paires de lignes de bit complémentaires (BL, BLb) ;
   - des lignes de source (SL) ;
   - un ensemble de cellules mémoire (12) organisées selon une matrice (14) comportant des rangées (16) et des colonnes (18), les cellules mémoire (12) d'une même rangée (16) étant sélectionnables par au moins une ligne de mot (WL), les cellules mémoire (12) d'une même colonne (18) étant reliées à une paire de lignes de bit complémentaires (BL, BLb) et au moins une ligne de source (SL) ;
   chaque cellule mémoire (12) comportant au moins une paire de memristors et au moins une paire de commutateurs, chaque memristor d'une cellule mémoire (12) respective étant connecté à un commutateur respectif et relié à la même ligne de source (SL) lors de chaque opération de calcul, chaque paire de memristors mémorisant respectivement une valeur binaire en présentant respectivement des première et deuxième valeurs de résistances différentes ; les commutateurs étant reliés, pour leur activation, à une ligne de mot (WL) respective et reliés respectivement à une paire de lignes de bit complémentaires (BL, BLb), les deux commutateurs d'une paire respective étant reliés à une même ligne de mot (WL) ; et
   - un module de lecture (24) mis en œuvre lors de chaque opération de calcul, le module de lecture (24) comportant:

      + une unité logique (50) pour chaque colonne (18), chaque unité logique (50) comprenant au moins une borne d'entrée (52) connectée à une ligne de source (SL) respective pour recevoir une valeur d'entrée dite valeur de colonne, l'unité logique (50) étant propre à effectuer une opération logique présentant un basculement entre une valeur basse et une valeur haute en fonction d'une comparaison de la valeur de colonne par rapport à une valeur de seuil de basculement (INV$_{th}$), lors de l'opération de calcul, l'unité logique (50) formant un inverseur logique lors de l'opération de calcul, **caractérisé en ce que** le module de lecture (24) comporte:

+ une unité de modification (60) propre à modifier, pour au moins une unité logique (50) et en fonction de l'opération de calcul souhaitée, une différence entre la valeur de colonne et la valeur de seuil de basculement (INV$_{th}$).

2. Circuit électronique (10) selon la revendication 1, dans lequel l'unité de modification (60) est propre à modifier la différence entre la valeur de colonne et la valeur de basculement (INVt$_h$) pour une unité logique (50) respective, en commandant une modification des tensions complémentaires appliquées sur la paire de lignes de bit complémentaires (BL, BLb) pour la colonne (18) associée à ladite unité logique (50).

3. Circuit électronique (10) selon la revendication 1 ou 2, dans lequel l'unité de modification (60) est propre à modifier la différence entre la valeur de colonne et la valeur de seuil pour une unité logique (50) respective, en commandant une modification de la valeur de seuil de ladite unité logique (50) ;
ladite valeur de seuil étant de préférence modifiée via un changement de la tension d'alimentation de ladite unité logique (50) et/ou via un changement de la tension de polarisation d'une grille arrière d'au moins un transistor de ladite unité logique (50).

4. Circuit électronique (10) selon l'une quelconque des revendications précédentes, dans lequel l'unité de modification (60) est propre à modifier, de manière incrémentale selon un pas d'incrémentation prédéfini, ladite différence entre la valeur de colonne et la valeur de seuil de basculement (INV$_{th}$), pour déterminer - parmi une pluralité de valeurs possibles prédéfinies - une valeur résultante correspondant à la tension de la ligne de source (SL) respective correspondant à ladite valeur de colonne ; le pas d'incrémentation dépendant de ladite pluralité de valeurs possibles.

5. Circuit électronique (10) selon la revendication 4, dans lequel le module de lecture (24) comporte en outre une unité de mémorisation (80) pour au moins une colonne (18), chaque unité de mémorisation (80) étant propre à stocker la valeur résultante déterminée pour la colonne (18) respective, dans l'attente de la détermination de toutes les valeurs résultantes pour un groupe respectif de plusieurs colonnes (18) ;
chaque unité de mémorisation (80) comportant de préférence un registre de bits (82) pour stocker sous forme binaire ladite valeur résultante déterminée.

6. Circuit électronique (10) selon la revendication 4 ou 5, dans lequel le module de lecture (24) comporte en outre une unité d'extinction (70) pour chaque colonne (18), chaque unité d'extinction (70) étant propre - après détermination de la valeur résultante pour la colonne (18) respective et dans l'attente de la détermination de toutes les valeurs résultantes pour un groupe respectif - à commander l'application de la même tension à la paire de lignes de bit complémentaires (BL, BLb) pour la circulation d'un courant sensiblement nul dans la ligne de source (SL) de la colonne (18) respective.

7. Circuit électronique (10) selon l'une quelconque des revendications précédentes, dans lequel chaque cellule mémoire (12) comporte deux paires de memristors et deux paires de commutateurs.

8. Circuit électronique (10) selon la revendication 7, dans lequel une première paire de commutateurs (32, 34) est reliée à une première ligne de mot (WL) assignée à une entrée (IN), et respectivement une deuxième paire de commutateurs (34, 32) est reliée à une deuxième ligne de mot (WLb) assignée à l'inverse de ladite entrée (IN) ; et dans lequel une première paire de memristors (28, 30) est associée à la première paire de commutateurs (32, 34) et mémorisant une valeur binaire (w), et respectivement une deuxième paire de memristors (30, 28) est associée à la deuxième paire de commutateurs (34, 32) et mémorisant l'inverse de la même valeur binaire (w).

9. Circuit électronique (10) selon l'une quelconque des revendications 1 à 6, dans lequel chaque cellule mémoire (12) comporte une seule paire de memristors et une seule paire de commutateurs, chaque paire de memristors mémorisant respectivement un poids synaptique.

10. Circuit électronique (10) selon l'une quelconque des revendications précédentes, dans lequel l'opération logique effectuée par l'unité logique (50) est une inversion, et l'opération de calcul associée est choisie parmi : une opération de calcul neuronal, telle que l'opération MAC ; une opération ET ; une opération OU ; une opération Majorité.

11. Circuit électronique (10) selon l'une quelconque des revendications précédentes, dans lequel la valeur du seuil de basculement (INVt$_h$) dépend de l'opération de calcul associée ;

lorsque l'opération de calcul associée est l'opération ET ou l'opération OU, la valeur du seuil de basculement (INVt$_h$) étant de préférence à un pas de tension d'une tension de ligne bit (BL, BLb) correspondante, la tension de ligne bit (BL, BLb) correspondante étant l'une des tensions de lignes de bit complémentaires (BL, BLb) pour l'opération ET et l'autre desdites tensions pour l'opération OU, le pas de tension vérifiant l'équation suivante :

$$P = \frac{\Delta BL}{OPD + 1}$$

où P représente le pas de tension ;
$\Delta$BL représente le différentiel de tension entre la tension de la ligne de bit (BL) et la tension de la ligne de bit complémentaire (BLb), et
OPD représente le nombre d'opérandes auxquelles l'opération de calcul est appliquée ;
lorsque l'opération de calcul associée est l'opération Majorité, la valeur du seuil de basculement (INVt$_h$) étant de préférence une valeur médiane des tensions de lignes de bit complémentaires (BL, BLb).

12. Circuit électronique (10) selon la revendication 10 ou 11, dans lequel le module de lecture (24) comporte en outre une unité de combinaison (90) pour au moins une colonne (18), chaque unité de combinaison (90) étant propre à combiner les résultats d'opérations logiques effectuées successivement par une unité logique (50) respective, pour mettre en œuvre une opération logique combinée ;

chaque unité de combinaison (90) comportant de préférence une bascule (92) connectée en sortie de l'unité logique (50) respective ;
l'opération logique combinée étant de préférence encore choisie parmi le groupe consistant en : une opération de ou-exclusif et une opération de non-ou-exclusif.

13. Circuit électronique (10) selon l'une quelconque des revendications précédentes, dans lequel l'unité logique (50) est une porte logique comportant une sortie et réalisant une fonction booléenne entre plusieurs entrées, une entrée étant la borne d'entrée (52) connectée à la ligne de source (SL) et la ou les autres entrées étant positionnées dans un état logique neutre lors de l'opération de calcul, de sorte que l'unité logique (50) se comporte comme un inverseur entre la borne d'entrée (52) connectée à la ligne de source (SL) et la sortie.

14. Circuit électronique (10) selon l'une quelconque des revendications précédentes, dans lequel chaque cellule mémoire (12) d'une colonne (18) respective comprend au moins une paire de sous-cellules, chaque sous-cellule comportant un memristor et un commutateur, chaque memristor d'une sous-cellule respective étant connecté à une ligne de source et à un commutateur respectifs, les memristors de chaque paire de sous-cellules mémorisant respectivement une valeur binaire en présentant respectivement des première et deuxième valeurs de résistances différentes ; les commutateurs étant reliés, pour leur activation, à une ligne de mot (WL) respective et reliés respectivement à une paire de lignes de bit complémentaires (BL, BLb), les deux commutateurs d'une paire respective de sous-cellules étant reliés à une même ligne de mot (WL) ; les deux lignes de source associées à une paire respective de sous-cellules étant connectées entre elles via un commutateur auxiliaire lors de chaque opération de calcul et formant alors la même ligne de source (SL) à laquelle chaque memristor d'une cellule mémoire (12) respective est relié lors de chaque opération de calcul.

15. Circuit électronique (10) selon l'une quelconque des revendications précédentes, dans lequel le circuit électronique (10) est un circuit neuromorphique propre à mettre en œuvre un réseau de neurones à sortie binaire, chaque cellule mémoire (12) étant associée à un poids synaptique respectif d'un neurone, et les lignes de mot (WL) étant aptes à recevoir des tensions d'entrée lors d'une opération de calcul neuronal.

16. Circuit électronique (10) selon l'une quelconque des revendications précédentes, comprenant un premier contrôleur (20) permettant de sélectionner les cellules mémoire (12) d'une rangée (16) qui sont reliées à une même ligne de mot (WL), et comprenant un deuxième contrôleur (22) relié aux paires de lignes de bit (BL, BLb) et permettant d'appliquer sur chaque paire de ligne de bit (BL, BLb) des tensions différentes et symétriques par rapport à une tension milieu, la tension appliquée sur une ligne de bit (BL) étant supérieure ou inférieur à celle appliquée sur la ligne de bit complémentaire (BLb) associée.

**17.** Circuit électronique (10) selon l'une quelconque des revendications précédentes, dans lequel le circuit électronique (10) comporte plusieurs ensembles distincts de cellules mémoire (12) propres à fonctionner en parallèle.

**Patentansprüche**

**1.** Elektronische Schaltung (10), die geeignet ist, Rechenoperationen durchzuführen, die jeweils eine binäre Ausgabe liefern, wobei die Schaltung Folgendes umfasst:

- Wortleitungen (WL);
- Paare komplementärer Bitleitungen (BL, BLb);
- Source-Leitungen (SL);
- eine Anordnung von Speicherzellen (12), die gemäß einer Matrix (14) organisiert sind, die Zeilen (16) und Spalten (18) aufweist, wobei die Speicherzellen (12) derselben Zeile (16) durch mindestens eine Wortleitung (WL) auswählbar sind, wobei die Speicherzellen (12) derselben Spalte (18) mit einem Paar komplementärer Bitleitungen (BL, BLb) und mindestens einer Source-Leitung (SL) verbunden sind; wobei jede Speicherzelle (12) mindestens ein Paar Memristoren und mindestens ein Paar Schalter aufweist, wobei jeder Memristor einer jeweiligen Speicherzelle (12) an einen jeweiligen Schalter angeschlossen und bei jeder Rechenoperation mit derselben Source-Leitung (SL) verbunden ist, wobei jedes Paar Memristoren jeweils einen binären Wert speichert, indem jeweils ein unterschiedlicher erster und zweiter Widerstandswert vorgelegt werden; wobei die Schalter für ihre Aktivierung mit einer jeweiligen Wortleitung (WL) verbunden und jeweils mit einem Paar komplementärer Bitleitungen (BL, BLb) verbunden sind, die beiden Schalter eines jeweiligen Paares mit derselben Wortleitung (WL) verbunden sind; und
- ein Lesemodul (24), das bei jeder Rechenoperation eingesetzt wird,

wobei das Lesemodul (24) Folgendes aufweist:

+ eine logische Einheit (50) für jede Spalte (18), wobei jede logische Einheit (50) mindestens einen Eingangsanschluss (52) umfasst, der an eine jeweilige Source-Leitung (SL) angeschlossen ist, um einen als Spaltenwert bezeichneten Eingangswert zu empfangen, wobei die logische Einheit (50) geeignet ist, eine logische Operation durchzuführen, die ein Umschalten zwischen einem niedrigen Wert und einem hohen Wert in Abhängigkeit von einem Vergleich des Spaltenwerts mit einem Umschaltschwellenwert ($INVt_h$) bei der Rechenoperation aufweist, wobei die logische Einheit (50) bei der Rechenoperation einen logischen Inverter bildet, **dadurch gekennzeichnet, dass** das Lesemodul (24) Folgendes aufweist:

+ eine Änderungseinheit (60), die geeignet ist, für mindestens eine logische Einheit (50) und in Abhängigkeit von der gewünschten Rechenoperation eine Differenz zwischen dem Spaltenwert und dem Umschaltschwellenwert ($INVt_h$) zu ändern.

**2.** Elektronische Schaltung (10) nach Anspruch 1, wobei die Änderungseinheit (60) geeignet ist, die Differenz zwischen dem Spaltenwert und dem Umschaltwert ($INV_{th}$) für eine jeweilige logische Einheit (50) zu ändern, indem sie eine Änderung der komplementären Spannungen befiehlt, die an das Paar komplementärer Bitleitungen (BL, BLb) für die Spalte (18) angelegt werden, die der logischen Einheit (50) zugeordnet ist.

**3.** Elektronische Schaltung (10) nach Anspruch 1 oder 2, wobei die Änderungseinheit (60) geeignet ist, die Differenz zwischen dem Spaltenwert und dem Schwellenwert für eine jeweilige logische Einheit (50) zu ändern, indem sie eine Änderung des Schwellenwerts der logischen Einheit (50) befiehlt; wobei der Schwellenwert vorzugsweise durch eine Veränderung der Versorgungsspannung der logischen Einheit (50) und/oder durch eine Veränderung der Polarisationsspannung eines hinteren Gates mindestens eines Transistors der logischen Einheit (50) geändert wird.

**4.** Elektronische Schaltung (10) nach einem der vorhergehenden Ansprüche, wobei die Änderungseinheit (60) geeignet ist, die Differenz zwischen dem Spaltenwert und dem Umschaltschwellenwert ($INV_{th}$) inkrementell gemäß einem vordefinierten Inkrementschritt zu ändern, um - aus einer Vielzahl vordefinierter möglicher Werte - einen resultierenden Wert zu bestimmen, der der Spannung der jeweiligen Source-Leitung (SL) entspricht, die dem Spaltenwert entspricht; wobei der Inkrementschritt von der Vielzahl möglicher Werte abhängt.

**5.** Elektronische Schaltung (10) nach Anspruch 4, wobei das Lesemodul (24) ferner eine Speichereinheit (80) für mindestens eine Spalte (18) aufweist, wobei jede Speichereinheit (80) geeignet ist, den für die jeweilige Spalte (18) bestimmten resultierenden Wert in Erwartung der Bestimmung aller resultierenden Werte für eine jeweilige Gruppe mehrerer Spalten (18) zu speichern;

wobei jede Speichereinheit (80) vorzugsweise ein Bitregister (82) zum Speichern des bestimmten resultierenden Werts in binärer Form aufweist.

6. Elektronische Schaltung (10) nach Anspruch 4 oder 5, wobei das Lesemodul (24) ferner eine Extinktionseinheit (70) für jede Spalte (18) aufweist, wobei jede Extinktionseinheit (70) geeignet ist - nach Bestimmung des resultierenden Wertes für die jeweilige Spalte (18) und in Erwartung der Bestimmung aller resultierenden Werte für eine jeweilige Gruppe - das Anlegen der gleichen Spannung an das Paar komplementärer Bitleitungen (BL, BLb) für das Fließen eines Stroms von im Wesentlichen Null in der Source-Leitung (SL) der jeweiligen Spalte (18) zu befehlen.

7. Elektronische Schaltung (10) nach einem der vorhergehenden Ansprüche, wobei jede Speicherzelle (12) zwei Paare Memristoren und zwei Paare Schalter aufweist.

8. Elektronische Schaltung (10) nach Anspruch 7, wobei ein erstes Paar Schalter (32, 34) mit einer ersten Wortleitung (WL) verbunden ist, die einem Eingang (IN) zugewiesen ist, und jeweils ein zweites Paar Schalter (34, 32) mit einer zweiten Wortleitung (WLb) verbunden ist, die der Inversion des Eingangs (IN) zugewiesen ist; und wobei ein erstes Paar Memristoren (28, 30) dem ersten Paar Schalter (32, 34) zugeordnet ist und einen binären Wert (w) speichert, und jeweils ein zweites Paar Memristoren (30, 28) dem zweiten Paar Schalter (34, 32) zugeordnet ist und die Inversion desselben binären Wertes (w) speichert.

9. Elektronische Schaltung (10) nach einem der Ansprüche 1 bis 6, wobei jede Speicherzelle (12) ein einziges Paar Memristoren und ein einziges Paar Schalter aufweist, wobei jedes Paar Memristoren jeweils ein synaptisches Gewicht speichert.

10. Elektronische Schaltung (10) nach einem der vorhergehenden Ansprüche, wobei die von der logischen Einheit (50) ausgeführte logische Operation eine Inversion ist und die zugeordnete Rechenoperation aus einer neuronalen Rechenoperation wie der MAC-Operation; einer UND-Operation; einer ODER-Operation; einer Majoritätsfunktion ausgewählt ist.

11. Elektronische Schaltung (10) nach einem der vorhergehenden Ansprüche, wobei der Umschaltschwellenwert (INVt$_h$) von der zugehörigen Rechenoperation abhängt;

wobei, wenn die zugeordnete Rechenoperation die UND-Operation oder die ODER-Operation ist, der Umschaltschwellenwert (INVt$_h$) vorzugsweise bei einem Spannungsschritt einer entsprechenden Spannung der Bitleitung (BL, BLb) liegt, wobei die entsprechende Spannung der Bitleitung (BL, BLb) eine der Spannungen der komplementären Bitleitungen für die UND-Operation und die andere der Spannungen für die ODER-Operation ist, wobei der Spannungsschritt die folgende Gleichung erfüllt:

$$P = \frac{\Delta BL}{OPD + 1}$$

wobei P den Spannungsschritt darstellt;

$\Delta$BL das Spannungsdifferential zwischen der Spannung der Bitleitung (BL) und der Spannung der komplementären Bitleitung (BLb) darstellt, und

OPD die Anzahl der Operanden darstellt, auf die die Rechenoperation angewendet wird;

wenn die zugeordnete Rechenoperation die Majoritätsfunktion ist, ist der Umschaltschwellenwert (INV$_{th}$) vorzugsweise ein Medianwert der Spannungen der komplementären Bitleitungen (BL, BLb) ist.

12. Elektronische Schaltung (10) nach Anspruch 10 oder 11, wobei das Lesemodul (24) ferner eine Kombinationseinheit (90) für mindestens eine Spalte (18) aufweist, wobei jede Kombinationseinheit (90) geeignet ist, die Ergebnisse logischer Operationen, die nacheinander von einer jeweiligen logischen Einheit (50) durchgeführt werden, zu kombinieren, um eine kombinierte logische Operation durchzuführen;

wobei jede Kombinationseinheit (90) vorzugsweise einen Flip-Flop (92) aufweist, der am Ausgang der jeweiligen logischen Einheit (50) angeschlossen ist;

wobei die kombinierte logische Operation vorzugsweise weiter aus der Gruppe ausgewählt ist, die aus einer Oder-exklusiven Operation und einer Nicht-oder-exklusiven Operation besteht.

13. Elektronische Schaltung (10) nach einem der vorhergehenden Ansprüche, wobei die logische Einheit (50) ein logisches Gatter ist, das einen Ausgang aufweist und eine Boolesche Funktion zwischen mehreren Eingängen realisiert, wobei ein Eingang der an die Source-Leitung (SL) angeschlossene Eingangsanschluss (52) ist und der oder die anderen Eingänge bei der Rechenoperation in einem neutralen logischen Zustand positioniert sind, so dass sich die logische Einheit (50) wie ein Inverter zwischen dem an die Source-Leitung (SL) angeschlossenen Eingangsanschluss (52) und dem Ausgang verhält.

14. Elektronische Schaltung (10) nach einem der vorhergehenden Ansprüche, wobei jede Speicherzelle (12) einer jeweiligen Spalte (18) mindestens ein Paar Unterzellen umfasst, wobei jede Unterzelle einen Memristor und einen Schalter aufweist, wobei jeder Memristor einer jeweiligen Unterzelle an eine jeweilige Source-Leitung und an einen jeweiligen Schalter angeschlossen ist, wobei die Memristoren jedes Paars Unterzellen jeweils einen binären Wert speichern, indem sie jeweils einen unterschiedlichen ersten und zweiten Widerstandswert aufweisen; wobei die Schalter für ihre Aktivierung mit einer jeweiligen Wortleitung (WL) verbunden und jeweils mit einem Paar komplementärer Bitleitungen (BL, BLb) verbunden sind, wobei die beiden Schalter eines jeweiligen Paars Unterzellen mit derselben Wortleitung (WL) verbunden sind; wobei die beiden Source-Leitungen, die einem jeweiligen Paar Unterzellen zugeordnet sind, bei jeder Rechenoperation über einen Hilfsschalter aneinander angeschlossen sind und dann dieselbe Source-Leitung (SL) bilden, mit der jeder Memristor einer jeweiligen Speicherzelle (12) bei jeder Rechenoperation verbunden ist.

15. Elektronische Schaltung (10) nach einem der vorhergehenden Ansprüche, wobei die elektronische Schaltung (10) eine neuromorphe Schaltung ist, die geeignet ist, ein neuronales Netz mit binärem Ausgang umzusetzen, wobei jede Speicherzelle (12) einem jeweiligen synaptischen Gewicht eines Neurons zugeordnet ist und die Wortleitungen (WL) geeignet sind, Eingangsspannungen bei einer neuronalen Rechenoperation zu empfangen.

16. Elektronische Schaltung (10) nach einem der vorhergehenden Ansprüche, umfassend eine erste Steuerung (20), die gestattet, Speicherzellen (12) einer Reihe (16) auszuwählen, die mit derselben Wortleitung (WL) verbunden sind, und umfassend eine zweite Steuerung (22), die mit den Paaren der Bitleitungen (BL, BLb) verbunden ist und gestattet, an jedes Paar einer Bitleitung (BL, BLb) unterschiedliche Spannungen anzulegen, die symmetrisch zu einer mittleren Spannung sind, wobei die an eine Bitleitung (BL) angelegte Spannung höher oder niedriger ist als die an die zugeordnete komplementäre Bitleitung (BLb) angelegte Spannung.

17. Elektronische Schaltung (10) nach einem der vorhergehenden Ansprüche, wobei die elektronische Schaltung (10) mehrere unterschiedliche Anordnungen von Speicherzellen (12) aufweist, die geeignet sind, parallel zu arbeiten.

**Claims**

1. An electronic circuit (10) suitable for implementing computation operations each providing a binary output, the circuit comprising:

   - word lines (WL);
   - pairs of complementary bit lines (BL, BLb);
   - source lines (SL);
   - a set of memory cells (12) organized in a matrix (14) including rows (16) and columns (18), the memory cells (12) of the same row (16) being selectable by at least one word line (WL), the memory cells (12) of the same column (18) being linked to a pair of complementary bit lines (BL, BLb) and at least one source line (SL);
   each memory cell (12) having at least one pair of memristors and at least one pair of switches, each memristor of a respective memory cell (12) being connected to a respective switch and linked to the same source line (SL) during each computation operation, each pair of memristors correspondingly storing a binary value presenting, correspondingly, first and second different resistance values; the switches being linked, for activation, to a respective word line (WL) and correspondingly linked to a pair of complementary bit lines (BL, BLb), the two switches of a respective pair being linked to the same word line (WL);
   - a reading module (24) implemented during each computation operation, the reading module (24) including:

      + a logic unit (50) for each column (18), each logic unit (50) comprising at least one input terminal (52) connected to a respective source line (SL), for receiving an input value called a column value, the logic unit (50) being suitable for performing a logic operation which toggles between a low value and a high value depending on a comparison of the column value with a toggle threshold value ($INV_{th}$), during the computation operation, the logic unit (50) forming a logic inverter during the computation operation,

**characterized in that** the reading module (24) includes:

+ a modification unit (60) suitable for modifying, for at least one logic unit (50) and according to the desired computation operation, a difference between the column value and the toggle threshold value ($INV_{th}$).

2. The electronic circuit (10) according to claim 1, wherein the modification unit (60) is suitable for modifying the difference between the column value and the toggle value ($INVt_h$) for a respective logic unit (50), by commanding a modification of the complementary voltages applied to the pair of complementary bit lines (BL, BLb) for the column (18) associated with said logic unit (50).

3. The electronic circuit (10) according to claim 1 or 2, wherein the modification unit (60) is suitable for modifying the difference between the column value and the threshold value for a respective logic unit (50), by commanding a modification of the threshold value of said logic unit (50);
said threshold value being preferentially modified via by change in the supply voltage of said logic unit (50) and/or by a change in the bias voltage of a rear gate of at least one transistor of said logic unit (50).

4. The electronic circuit (10) according to any of the preceding claims, wherein the modification unit (60) is suitable for modifying, incrementally according to a predefined incrementation step, said difference between the column value and the toggle threshold value ($INV_{th}$), for determining - among a plurality of predefined possible values - a resulting value corresponding to the voltage of the respective source line (SL) corresponding to said column value; the incrementation step depending on said plurality of possible values.

5. The electronic circuit (10) according to claim 4, wherein the reading module (24) further includes a storage unit (80) for at least one column (18), each storage unit (80) being suitable for storing the resulting value determined for the respective column (18), pending the determination of all the resulting values for a respective group of a plurality of columns (18);
each storage unit (80) preferentially including a bit register (82) for storing said determined resulting value in binary form.

6. The electronic circuit (10) according to claim 4 or 5, wherein the reading module (24) further includes an extinction unit (70) for each column (18), each extinction unit (70) being suitable - after determining the resulting value for the respective column (18) and pending determination of all the resulting values for a respective group - for commanding the application of the same voltage to the pair of complementary bit lines (BL, BLb) for the circulation of a substantially zero current in the source line (SL) of the respective column (18).

7. The electronic circuit (10) according to any of the preceding claims, wherein each memory cell (12) includes two pairs of memristors and two pairs of switches.

8. The electronic circuit (10) according to claim 7, wherein a first pair of switches (32, 34) is linked to a first word line (WL) assigned to an input (IN), and a second pair of switches (34, 32), respectively, is linked to a second word line (WLb) assigned to the inverse of said input (IN); and wherein a first pair of memristors (28, 30) is associated with the first pair of switches (32, 34) and storing a binary value (w), and a second pair of memristors (30, 28), respectively, being associated with the second pair of switches (34, 32) and storing the inverse of the same binary value (w);

9. The electronic circuit (10) according to any of claims 1 to 6, wherein each memory cell (12) includes only one pair of memristors and only one pair of switches, each pair of memristors correspondingly storing a synaptic weight.

10. The electronic circuit (10) according to any of the preceding claims, wherein the logic operation performed by the logic unit (50) is an inversion, and the associated computation operation is chosen from: a neural computation operation, such as the MAC operation; an AND operation; an OR operation; a Majority operation.

11. The electronic circuit (10) according to any of the preceding claims, wherein the value of the toggle threshold ($INVt_h$) depends on the associated computation operation;

when the associated computation operation is the AND operation or the OR operation, the value of the toggle threshold ($INVt_h$) being preferentially at a voltage step of a voltage of a corresponding bit line (BL, BLb), the corresponding voltage of the bit line (BL, BLb) being one of the voltages of the complementary bit lines (BL, BLb) for the AND operation and the other of the voltages complementary bit lines for the OR operation, the voltage step satisfying the following equation:

$$P = \frac{\Delta BL}{OPD + 1}$$

where P represents the voltage step;

$\Delta BL$ represents the voltage differential between the voltage of the bit line (BL) and the voltage of the complementary bit line (BLb), and

OPD represents the number of operands to which the computation operation is applied;

when the associated computation operation is the Majority operation, the value of the toggle threshold ($IN_{th}$) preferentially being a median value of the voltages of the complementary bit lines (BL, BLb).

12. The electronic circuit (10) according to claim 10 or 11, wherein the reading module (24) further comprises a combination unit (90) for at least one column (18), each combination unit (90) being suitable for combining the results of logic operations performed successively by a respective logic unit (50), for implementing a combined logic operation;

each combination unit (90) preferentially including a flip-flop (92) connected to the output of the respective logic unit (50);

the combined logic operation being preferentially further chosen from the group consisting of: an exclusive OR operation and an exclusive NOR.

13. The electronic circuit (10) according to any of the preceding claims, wherein the logic unit (50) is a logic gate having an output and performing a Boolean function between a plurality of inputs, one input being the input terminal (52) connected to the source line (SL) and the other input(s) being positioned in a neutral logic state during the computation operation, so that the logic unit (50) behaves as an inverter between the input terminal (52) connected to the source line (SL) and the output.

14. The electronic circuit (10) according to any of the preceding claim, wherein each memory cell (12) of a respective column (18) comprises at least one pair of sub-cells, each sub-cell including a memristor and a switch, each memristor of a respective sub-cell being connected to a respective source line and switch, the memristors of each pair of sub-cells correspondingly storing a binary value by correspondingly presenting first and second different resistance values; the switches being linked, for the activation thereof, to a respective word line (WL) and correspondingly linked to a pair of complementary bit lines (BL, BLb), the two switches of a respective pair of sub-cells being linked to the same word line (WL); the two source lines associated with a respective pair of sub-cells being connected to each other via an auxiliary switch during each computation operation and then forming the same source line (SL) to which each memristor of a respective memory cell (12) is linked during each computation operation.

15. The electronic circuit (10) according to any of the preceding claims, wherein the electronic circuit (10) is a neuromorphic circuit suitable for implementing a neural network with binary output, each memory cell (12) being associated with a respective synaptic weight of a neuron, and the word lines (WL) being apt to receive input voltages during a neural computation.

16. The electronic circuit (10) according to any of the preceding claims, comprising a first controller (20) for selecting the memory cells (12) of a row (16) which are linked to the same word line (WL), and comprising a second controller (22) linked to the pairs of bit lines (BL, BLb) and used for applying different voltages to each pair bit line (BL, BLb) and symmetrical with respect to a middle voltage, the voltage applied to a bit line (BL) being either higher or lower than the voltage applied to the associated complementary bit line (BLb).

17. The electronic circuit (10) according to any of the preceding claims, wherein the electronic circuit (10) includes a plurality of distinct sets of memory cells (12) suitable for operating in parallel.

## FIG.1

EP 4 354 351 B1

FIG.2

## FIG.3

FIG.4

FIG.5

FIG.6

FIG.7

FIG.8

EP 4 354 351 B1

FIG.9

EP 4 354 351 B1

# FIG.10

EP 4 354 351 B1

FIG.11

FIG.12

EP 4 354 351 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **Q. LIU et al.** *A Fully Integrated Analog ReRAM Based 78.4TOPS/W Compute-In-Memory Chip with Fully Parallel MAC Computing*, 2020
- **C. XUE et al.** *A 1Mb Multibit ReRAM Computing-In-Memory Macro with 14.6ns Parallel MAC Computing Time for CNN Based AI Edge Processors*, 2019
- **C. XUE et al.** *A 22nm 4Mb 8b-Precision ReRAM Computing-in-Memory Macro with 11.91 to 195.7TOPS/W for Tiny AI Edge Devices*, 2021
- **W. CHEN et al.** *A 16Mb dual-mode ReRAM macro with sub-14ns computing-in-memory and memory functions enabled by self-write termination scheme*, 2017
- **C. XUE et al.** *Embedded 1-Mb ReRAM-Based Computing-in-Memory Macro With Multibit Input and Weight for CNN-Based AI Edge Processors*, 2019
- **L. WANG et al.** *Efficient and Robust Nonvolatile Computing-In-Memory Based on Voltage Division in 2T2R RRAM With Input-Dependent Sensing Control*, 2021
- **M. EZZADEEN et al.** *Low-Overhead Implementation of Binarized Neural Networks Employing Robust 2T2R Resistive RAM Bridges*, 2021